# EUROPEAN PATENT APPLICATION

(11) **EP 3 509 117 A1**
(43) Date of publication of application: **10.07.2019**
(21) Application number: 17846390.7
(22) Date of filing: 28.08.2017
(51) Int. Cl.: H01L 51/44

(54) **PHOTOELECTRIC CONVERSION ELEMENT, SOLAR BATTERY, METHOD FOR MANUFACTURING PHOTOELECTRIC CONVERSION ELEMENT, AND SURFACE TREATMENT AGENT FOR PEROVSKITE-TYPE CRYSTAL FILM**

(30) Priority: 31.08.2016 JP 2016168770
(71) Applicant: FUJIFILM Corporation, Tokyo 106-8620 (JP)
(72) Inventor: SHIROKANE, Kenji, Ashigarakami-gun Kanagawa 258-8577 (JP); SATOU, Hirotaka, Ashigarakami-gun Kanagawa 258-8577 (JP); ISE, Toshihiro, Ashigarakami-gun Kanagawa 258-8577 (JP)
(74) Representative: Hoffmann Eitle
(86) International application number: PCT/JP2017/030700
(87) International publication number: WO 2018/043385

(57) **Abstract**

Provided is a photoelectric conversion element in which a photosensitive layer is composed of a light absorbing agent containing a perovskite compound, the element including a protective layer that includes a compound having a molecular weight of 5000 or less which is represented by Formula (A), on a surface of the photosensitive layer; a method for manufacturing this photoelectric conversion element; and a solar cell which is formed of this photoelectric conversion element.

Formula (A) R^{A}-Z

In Formula (A), R^{A} represents a specific group. Z represents an acidic group or a salt thereof.

Further provided is a surface treating agent for a perovskite-type crystal film, including a compound having a molecular weight of 5000 or less which is represented by Formula (A).

## Description

### BACKGROUND OF THE INVENTION

### 1. Field of the Invention

The present invention relates to a photoelectric conversion element, a solar cell, a method for manufacturing a photoelectric conversion element, and a surface treating agent for a perovskite-type crystal film.

### 2. Description of the Related Art

Photoelectric conversion elements are used in a variety of optical sensors, copiers, solar cells, and the like. Practical use of solar cells as cells using non-exhaustible solar energy is proceeding. Among these, research and development of dye sensitized solar cells, in which an organic dye, a Ru bipyridyl complex, or the like is used as a sensitizer, are actively in progress, and the photoelectric conversion efficiency thereof reaches approximately 11%.

Meanwhile, in recent years, there have been reported research results indicating that solar cells using a metal halide as a compound having a perovskite-type crystal structure are capable of achieving relatively high photoelectric conversion efficiency, and the solar cells attract attention. For example, a solar cell formed of a metal halide represented by CH₃NH₃PbI₂Cl as a light absorbing agent is described in Science, 2012, vol. 338, p. 643-647.

In addition, in solar cells using a compound having a perovskite-type crystal structure as a light absorbing agent, researches to further enhance photoelectric conversion efficiency thereof are actively conducted. Improvement in photoelectrically converted performance by coating a surface of a perovskite-type crystal film with thiophene or pyridine is disclosed in, for example, ACS Nano, 2014, Vol. 8, No. 10, p. 9815-9821, or by coating a surface of a perovskite-type crystal film with a 4-styrenesulfonic acid lithium-styrene copolymer is disclosed in, for example, Advanced Functional Materials, 2015, Vol. 25, p. 6875-6884. Furthermore, Nanoscale, 2015, Vol. 7, p. 9443-9447 discloses that durability is improved by coating a surface of a perovskite-type crystal film with a thiol compound.

### SUMMARY OF THE INVENTION

As described above, in regard to a photoelectric conversion element formed of a compound having a perovskite-type crystal structure (hereinafter referred to as "perovskite compound"), certain achievements in improving a photoelectric conversion efficiency has been experimentally obtained. However, there is a problem that the perovskite compound is easily damaged under a high-humidity environment. That is, in a photoelectric conversion element which uses the perovskite compound in a photosensitive layer, the photoelectric conversion efficiency greatly deteriorates over time particularly at the time of being used under a high-humidity environment in many cases. It is perceived that the reason for this is because a crystal structure of the perovskite compound is damaged under a high-humidity environment, resulting in changes in a surface state of the photosensitive layer, and thus adhesiveness with an adjacent layer deteriorates.

An object of the present invention is to provide a photoelectric conversion element which uses a light absorbing agent containing a perovskite compound in a photosensitive layer, in which, even in a case of being used under a high-humidity environment, a crystal structure of the light absorbing agent constituting the photosensitive layer is unlikely to be damaged, and a deterioration in photoelectric conversion efficiency over time can be efficiently suppressed; and a solar cell formed of this photoelectric conversion element. Another object of the present invention is to provide a method for manufacturing the photoelectric conversion element; and a surface treating agent for a perovskite-type crystal film which is suitably used in the manufacturing method.

As a result of intensive investigations in view of the above problems, the inventors of the present invention have found that, in a photoelectric conversion element including a photosensitive layer in which at least a part of the layer is composed of a perovskite compound, by forming a layer containing a compound having a specific structure having an acidic group or a salt thereof, on a surface side of a second electrode of this photosensitive layer, a crystal structure of the photosensitive layer is unlikely to be damaged (which is decomposition of the crystal structure), and a deterioration in photoelectric conversion efficiency over time can be efficiently suppressed ever under a high-humidity environment. The present invention has been completed through investigation based on these findings.

That is, the above-described problem of the present invention has been solved by the following means.
[1] A photoelectric conversion element, comprising: a first electrode that includes a photosensitive layer containing a light absorbing agent on a conductive support; and a second electrode that is opposite to the first electrode,
   in which the light absorbing agent contains a compound having a perovskite-type crystal structure that has an organic cation, a cation of a metal atom, and an anion,
   the photoelectric conversion element further comprising a protective layer that includes a compound having a molecular weight of 5000 or less which is represented by Formula (A), on a surface side of the second electrode of the photosensitive layer.

   Formula (A) R^{A}-Z

   In Formula (A), R^{A} represents an alkyl group, an alkenyl group, an alkynyl group, a cycloalkyl group, an aryl group, a heteroaryl group, or an aliphatic heterocyclic group, provided that R^{A} does not have a silyl group as a substituent. Z represents an acidic group or a salt thereof.
[2] The photoelectric conversion element according to [1], in which, in a case where R^{A} is an alkyl group, the alkyl group is in an unsubstituted form or has a halogen atom, a cycloalkyl group, and/or an aryl group as a substituent,
   in a case where R^{A} is an alkenyl group or an alkynyl group, the alkenyl group and the alkynyl group are in an unsubstituted form or have a halogen atom, an 1-alkenyl group, an 1 -alkynyl group, a cycloalkyl group, and/or an aryl group as a substituent, and
   in a case where R^{A} is a cycloalkyl group, an aryl group, a heteroaryl group, or an aliphatic heterocyclic group, the cycloalkyl group, the aryl group, the heteroaryl group, and the aliphatic heterocyclic group are in an unsubstituted form or have a halogen atom, an alkyl group, an alkenyl group, an alkynyl group, a cycloalkyl group, and/or an aryl group as a substituent.
[3] The photoelectric conversion element according to [1] or [2], in which R^{A} is an alkyl group having 7 to 30 carbon atoms, or a cycloalkyl group or an aryl group.
[4] The photoelectric conversion element according to [3], in which R^{A} is represented by Formula (r1). 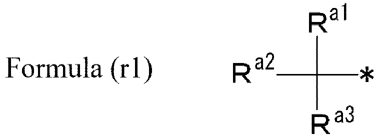 In Formula, R^{a1} and R^{a2} represent a halogen atom, an alkyl group, an alkenyl group, an alkynyl group, a cycloalkyl group, or an aryl group. R^{a3} represents a hydrogen atom, a halogen atom, an alkyl group, an alkenyl group, an alkynyl group, a cycloalkyl group, or an aryl group. * represents a binding site with Z.
[5] The photoelectric conversion element according to [4], in which the number of carbon atoms of R^{A} is 7 to 30.
[6] The photoelectric conversion element according to any one of [1] to [5], in which the Z is -COOH or a salt thereof, -SO₃H or a salt thereof, -P(=O)(OH)₂ or a salt thereof, or -B(OH)₂ or a salt thereof.
[7] The photoelectric conversion element according to [6], in which the Z is -SO₃H or a salt thereof, or -P(=O)(OH)₂ or a salt thereof.
[8] The photoelectric conversion element according to [7], in which the Z is -P(=O)(OH)₂ or a salt thereof.
[9] A solar cell which is formed of the photoelectric conversion element according to any one of [1] to [8].
[10] A method for manufacturing a photoelectric conversion element which includes a first electrode that includes a photosensitive layer containing a light absorbing agent on a conductive support, and a second electrode that is opposite to the first electrode,
   in which the light absorbing agent contains a compound having a perovskite-type crystal structure that has an organic cation, a cation of a metal atom, and an anion,
   the method comprising: after forming the photosensitive layer on the conductive support, bringing the photosensitive layer into contact with a solution containing a compound having a molecular weight of 5000 or less which is represented by Formula (A), to form a protective layer containing the compound on a surface of the photosensitive layer.

   Formula (A) R^{A}-Z

   In Formula (A), R^{A} represents an alkyl group, an alkenyl group, an alkynyl group, a cycloalkyl group, an aryl group, a heteroaryl group, or an aliphatic heterocyclic group, provided that R^{A} does not have a silyl group as a substituent. Z represents an acidic group or a salt thereof.
[11] A surface treating agent for a perovskite-type crystal film, comprising a compound having a molecular weight of 5000 or less which is represented by Formula (A).

   Formula (A) R^{A}-Z

   In Formula (A), R^{A} represents an alkyl group, an alkenyl group, an alkynyl group, a cycloalkyl group, an aryl group, a heteroaryl group, or an aliphatic heterocyclic group, provided that R^{A} does not have a silyl group as a substituent. Z represents an acidic group or a salt thereof.
[12] The surface treating agent for a perovskite-type crystal film according to [11], in which, in a case where R^{A} is an alkyl group, the alkyl group is in an unsubstituted form or has a halogen atom, a cycloalkyl group, and/or an aryl group as a substituent,
   in a case where R^{A} is an alkenyl group or an alkynyl group, the alkenyl group and the alkynyl group are in an unsubstituted form or have a halogen atom, an 1-alkenyl group, an 1-alkynyl group, a cycloalkyl group, and/or an aryl group as a substituent, and
   in a case where R^{A} is a cycloalkyl group, an aryl group, a heteroaryl group, or an aliphatic heterocyclic group, the cycloalkyl group, the aryl group, the heteroaryl group, and the aliphatic heterocyclic group are in an unsubstituted form or have a halogen atom, an alkyl group, an alkenyl group, an alkynyl group, a cycloalkyl group, and/or an aryl group as a substituent.
[13] The surface treating agent for a perovskite-type crystal film according to [11] or [12], further comprising a solvent.
[14] The surface treating agent for a perovskite-type crystal film according to [13], in which the solvent includes an aprotic solvent.
[15] The surface treating agent for a perovskite-type crystal film according to [13], in which the solvent includes an aprotic solvent and an alcohol, and a content of the alcohol in the solvent is from 1% to 50% by mass.
[16] The surface treating agent for a perovskite-type crystal film according to any one of [13] to [15], in which a content of a compound having a molecular weight of 5000 or less which is represented by Formula (A) is 0.01 to 100 mM in the surface treating agent for a perovskite-type crystal film.

In this specification, parts of respective formulae may be expressed as a rational formula for understanding of chemical structures of compounds. According to this, in the respective formulae, partial structures are called (substituent) groups, ions, atoms, and the like, but in this specification, the partial structures may represent element groups or elements which constitute (substituent) groups or ions represented by the formulae in addition to the (substituent) groups, the ions, the atoms, and the like.

In this specification, with regard to expression of compounds (including a complex and a dye), the expression is also used to indicate salts of the compounds and ions of the compounds in addition to the compounds. In addition, with regard to compounds for which substitution or non-substitution is not specified, the compounds also include compounds which have any substituent in a range not imparting a desired effect. This is also true of substituents, linking groups, and the like (hereinafter, referred to as "substituents and the like").

In this specification, in a case where a plurality of substituents and the like expressed using specific symbols or a plurality of substituents and the like are simultaneously defined, the respective substituents and the like may be identical to or different from each other unless otherwise stated. This is also true of definition of the number of substituents and the like. In addition, in a case of approaching each other (particularly, in a case of being close to each other), the plurality of substituents and the like may be linked to each other to form a ring unless otherwise stated. In addition, rings, for example, aliphatic rings, aromatic rings, and hetero rings may be additionally fused together to form a fused ring.

In the present specification, in a case of specifying the number of carbon atoms of a certain group, the number of carbon atoms means the number of carbon atoms of the whole group. That is, in a case where this group further has a substituent, the number of carbon atoms means a total number of carbon atoms including this substituent.

In this specification, numerical ranges represented by using "to" include ranges including numerical values before and after "to" as the lower limit and the upper limit.

In the photoelectric conversion element and the solar cell of the present invention, a crystal structure of the perovskite compound constituting the photosensitive layer is unlikely to be damaged even under a high-humidity environment, and a deterioration in photoelectric conversion efficiency over time at the time of being used under a high-humidity environment can be efficiently suppressed. In addition, according to the method for manufacturing a photoelectric conversion element of the present invention, it is possible to obtain the photoelectric conversion element exhibiting excellent moisture resistance. Furthermore, by coating a perovskite-type crystal film surface using the surface treating agent for a perovskite-type crystal film of the present invention, a damage on a crystal structure of the film can be effectively prevented even under a high-humidity environment.

The above and other features and advantages of the present invention will become more apparent from the following description with reference to the accompanying drawings as appropriate.

### BRIEF DESCRIPTION OF THE DRAWINGS

Fig. 1 is a cross-sectional view (including an enlarged view of a circle part in the layer) schematically illustrating a preferred aspect of a photoelectric conversion element of the present invention.
Fig. 2 is a cross-sectional view schematically illustrating another preferred aspect of the photoelectric conversion element having a thick photosensitive layer of the present invention.
Fig. 3 is a cross-sectional view schematically illustrating still another preferred aspect of the photoelectric conversion element of the present invention.
Fig. 4 is a cross-sectional view schematically illustrating still another preferred aspect of the photoelectric conversion element of the present invention.
Fig. 5 is a cross-sectional view schematically illustrating still another preferred aspect of the photoelectric conversion element of the present invention.
Fig. 6 is a cross-sectional view schematically illustrating still another preferred aspect of the photoelectric conversion element of the present invention.
Fig. 7A is a view schematically illustrating a perovskite-type crystal structure formed in a photosensitive layer of the photoelectric conversion element of the present invention.
Fig. 7B is a view schematically illustrating an example of a form of a protective layer in the photoelectric conversion element of the present invention.
Fig. 7C is a view schematically illustrating another example of a form of the protective layer in the photoelectric conversion element of the present invention.
Fig. 7D is a view schematically illustrating still another example of a form of the protective layer in the photoelectric conversion element of the present invention.
Fig. 7E is a view schematically illustrating still another example of a form of the protective layer in the photoelectric conversion element of the present invention.

### DESCRIPTION OF THE PREFERRED EMBODIMENTS

### [Photoelectric conversion element]

A photoelectric conversion element according to the embodiment of the invention includes a first electrode that has a form in which a photosensitive layer is provided on a conductive support, and a second electrode that is opposite to the first electrode. On a surface side of the second electrode of the photosensitive layer, a protective layer containing a compound having a specific structure to be described later is provided. A case where the first electrode and the second electrode are opposed to each other means an aspect in which the first electrode and the second electrode are laminated via the protective layer or via another layer in addition to the protective layer (that is, an aspect in which the first electrode and the second electrode are provided so as to be opposed to each other with another layer sandwiched therebetween). In the first electrode, the photosensitive layer is disposed on a side closer to the second electrode than the conductive support.

The photosensitive layer contains a light absorbing agent having specific kinds of organic cations, a metal cation, and an anion, in which at least a part of this light absorbing agent has a perovskite-type crystal structure. In a case where a portion that is not the perovskite-type crystal structure is present in the light absorbing agent, in this portion that is not the perovskite-type crystal structure, a state where the cation and the anion are bonded by an ionic bond can be adopted.

In the present invention, the case in which the photosensitive layer is provided on the conductive support or the photosensitive layer is formed on the conductive support means an aspect in which the photosensitive layer is provided to be in contact with (directly provided on) a surface of the conductive support, and an aspect in which the photosensitive layer is provided on an upper side of the surface of the conductive support through another layer.

In the aspect in which the photosensitive layer is provided on the upper side of the surface of the conductive support through another layer, as the other layer that is provided between the conductive support and the photosensitive layer, there is no particular limitation as long as the other layer does not deteriorate a cell performance of a solar cell. Examples thereof include a porous layer, a blocking layer, an electron transport layer, a hole transport layer, and the like.

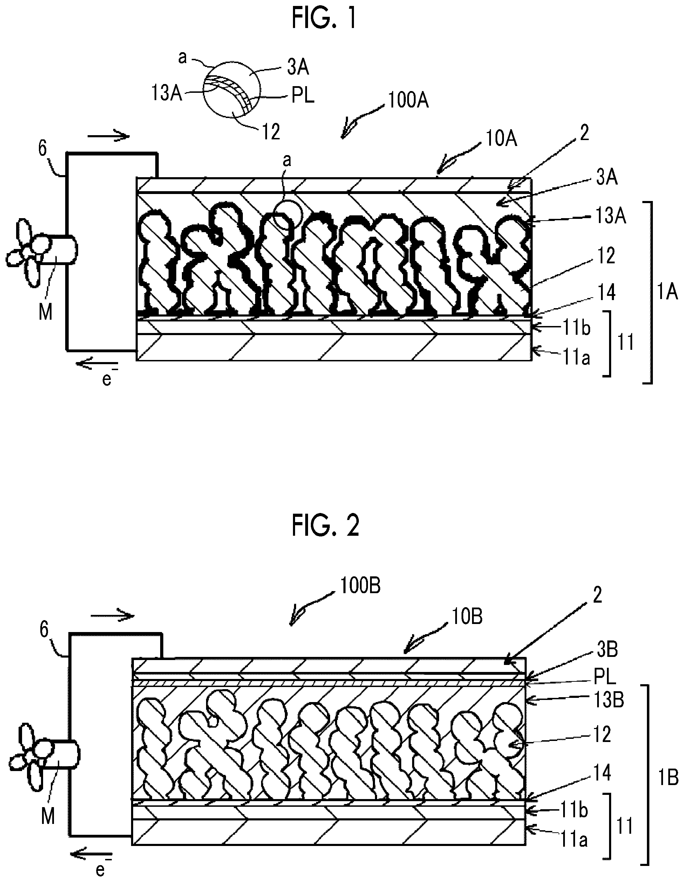

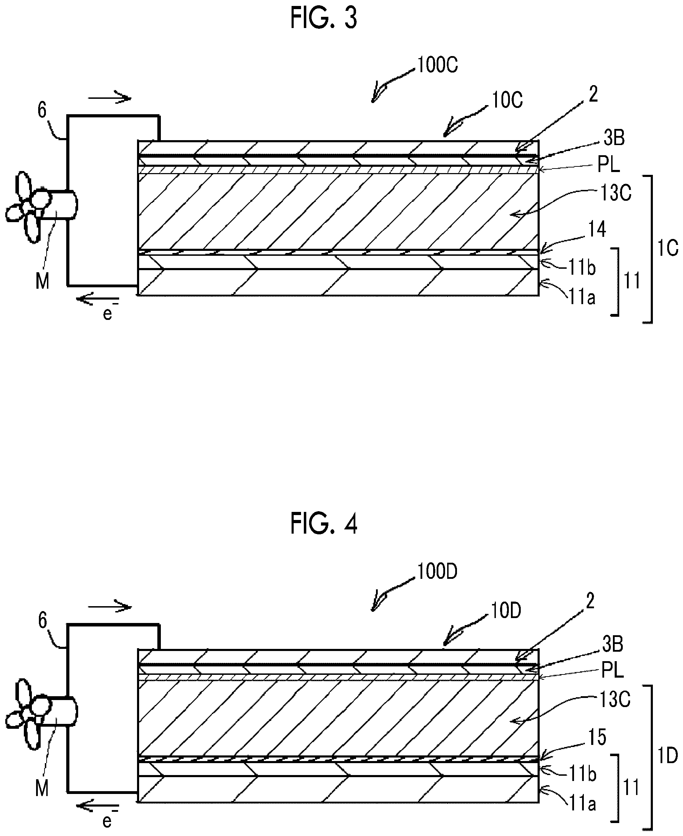

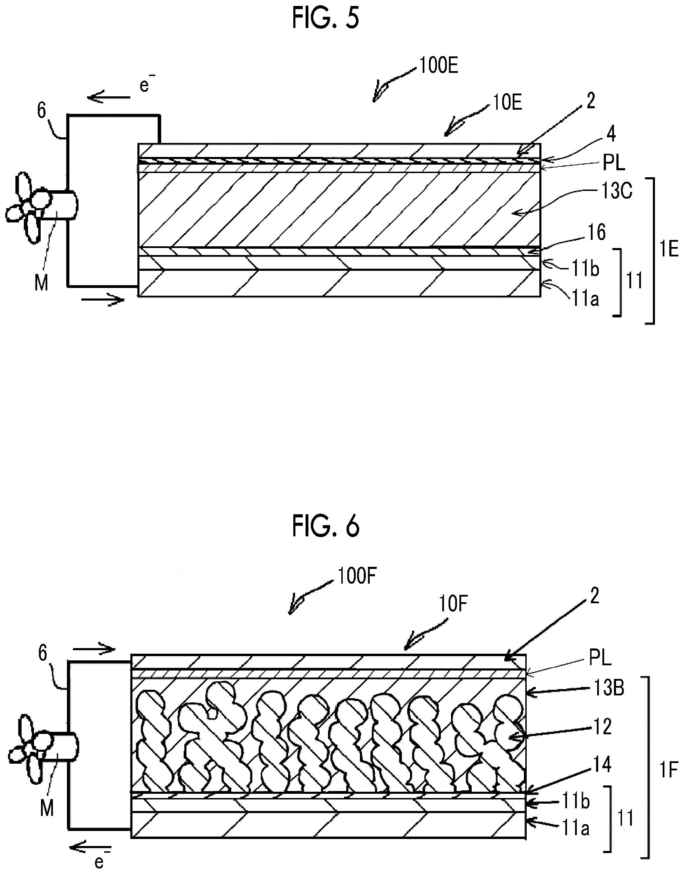

In the present invention, examples of the aspect in which the photosensitive layer is provided on the upper side of the surface of the conductive support through another layer includes an aspect in which the photosensitive layer is provided on the surface of the porous layer in a thin film shape (refer to Fig. 1) or in a thick film shape (refer to Figs. 2 and 6), an aspect in which the photosensitive layer is provided on a surface of the blocking layer in a thin film shape or a thick film shape (refer to Fig. 3), an aspect in which the photosensitive layer is provided on a surface of the electron transport layer in a thin film shape or a thick film shape (refer to Fig. 4), and an aspect in which the photosensitive layer is provided on a surface of the hole transport layer in a thin film shape or a thick film shape (refer to Fig. 5). The photosensitive layer may be provided in a linear shape or in a dispersed pattern, but is preferably provided in a film shape.

In the photoelectric conversion element according to the embodiment of the invention, the photosensitive layer contains the light absorbing agent having specific kinds of organic cations, a metal cation, and an anion, in which at least a part of this light absorbing agent is composed of a perovskite compound. On the surface side of the second electrode of the photosensitive layer, the protective layer containing the compound having a specific structure to be described later is provided. Accordingly, a damage on the crystal structure of the photosensitive layer can be suppressed even under a high-humidity environment, and a deterioration in photoelectric conversion efficiency over time can be efficiently suppressed even in a case where the photoelectric conversion element is used under a high-humidity environment.

In the present invention, the surface of the photosensitive layer surface means a surface on a side of the second electrode of the photosensitive layer. In the present invention, the sentence the "protective layer that includes a compound having a molecular weight of 5000 or less which is represented by Formula (A), on a surface of the photosensitive layer" means that the protective layer is present on the surface or in the vicinity of the photosensitive layer. The aspect in which the protective layer is present includes a case in which the compound is bonded to, in close contact with, fixed to, held to be carried by, adsorbed to, or the like, the surface of the photosensitive layer by a chemical bonding or a physical interaction. Examples of the aspect include an aspect in which the compound is covalently bonded, ionically bonded, or coordinate bonded to the surface of the photosensitive layer, an aspect in which the surface treating agent is physically adsorbed to the surface of the photosensitive layer, or an aspect in which the surface treating agent is replaced with a part of materials of the photosensitive layer. In the present invention, in which manner the protective layer having the compound is present on the surface of the photosensitive layer is not limited, as long as the protective layer having the compound is present on the surface or in the vicinity of the photosensitive layer.

For example, the protective layer having the compound may be present within a hole of a porous layer, or an aspect in which a part or all of the compounds forming the protective layer are incorporated into a photosensitive layer 13 may be adopted. Furthermore, a part of the compound forming the protective layer may be incorporated into the photosensitive layer 13 so as to be incorporated within the perovskite-type crystal structure. In the present invention, regardless of the presence or absence of the compound on the surface of the photosensitive layer, aggregation of the compound present on the surface of the photosensitive layer is referred to as the protective layer for the purpose of convenience. As such, as long as the protective layer having the compound is present on the surface of the photosensitive layer 13, the compound layer may be in any of a film form, a linear form, and a dispersed form, or may be in a mixed form thereof. The compound layer may not necessarily form a layer or a film which uniformly covers the surface of the photosensitive layer, but the compound layer is preferably provided in a form of a monolayer.

The form of the protective layer on the surface of the photosensitive layer will be described later in detail with reference to the drawings.

In the photoelectric conversion element of the embodiment of the invention, a configuration other than a configuration defined in the present invention is not particularly limited, and it is possible to employ a configuration that is known with respect to the photoelectric conversion element and a solar cell. Respective layers, which constitute the photoelectric conversion element of the embodiment of the invention, are designed in correspondence with the purposes thereof, and may be formed, for example, in a monolayer or multilayers.

Hereinafter, description will be given of preferred aspects of the photoelectric conversion element obtained by the manufacturing method of the embodiment of the invention.

In Figs. 1 to 6, the same reference numeral represents the same constituent element (member).

Furthermore, in Figs. 1, 2, and 6, the size of fine particles which form a porous layer 12 is illustrated in a highlighted manner. These fine particles are preferably packed with each other (are vapor-deposited or in close contact with each other) in the horizontal direction and the vertical direction with respect to a conductive support 11 to form a porous structure.

In this specification, simple description of "photoelectric conversion element 10" represents photoelectric conversion elements 10A to 10F unless otherwise stated. The same applies to a system 100 and a first electrode 1. In addition, simple description of "photosensitive layer 13" represents photosensitive layers 13A to 13C unless otherwise stated. Similarly, description of "hole transport layer 3" represents hole transport layers 3A and 3B unless otherwise stated.

Examples of a preferred aspect of the photoelectric conversion element obtained by the manufacturing method of the embodiment of the invention include the photoelectric conversion element 10A illustrated in Fig. 1. A system 100A illustrated in Fig. 1 is a system in which the photoelectric conversion element 10A is applied to use of a cell that allows operation means M (for example, an electric motor) to operate by an external circuit 6.

The photoelectric conversion element 10A includes a first electrode 1A, a second electrode 2, and a hole transport layer 3A between the first electrode 1A and the second electrode 2.

The first electrode 1A includes a conductive support 11 including a support 11a and a transparent electrode 11b, a porous layer 12, and a photosensitive layer 13A which is provided by the light absorbing agent containing the perovskite compound, on a surface of the porous layer 12 as schematically illustrated in enlarged cross-sectional region a in which a cross-sectional region a is enlarged in Fig. 1. A blocking layer 14 is provided on the transparent electrode 11b, and the porous layer 12 is formed on the blocking layer 14. As described above, in the photoelectric conversion element 10A including the porous layer 12, it is assumed that a surface area of the photosensitive layer 13A increases, and thus charge separation and charge migration efficiency are improved. In addition, in an aspect of Fig. 1, a protective layer PL to be described later is provided on the surface side of the second electrode of the photosensitive layer 13A.

Fig. 2 is a schematically illustrated view showing a preferred aspect of a photoelectric conversion element 10B in which the photosensitive layer 13A of the photoelectric conversion element 10A illustrated in Fig. 1 is provided to be thick, and the protective layer PL is provided thereon. In the photoelectric conversion element 10B, the hole transport layer 3B is provided to be thin. The photoelectric conversion element 10B is different from the photoelectric conversion element 10A illustrated in Fig. 1 in the film thickness of the photosensitive layer 13B and the hole transport layer 3B, but the photoelectric conversion element 10B has the same configuration as that of the photoelectric conversion element 10A except for the difference.

The photoelectric conversion element 10C illustrated in Fig. 3 schematically illustrates another preferred aspect of the photoelectric conversion element obtained by the manufacturing method of the embodiment of the invention. The photoelectric conversion element 10C is different from the photoelectric conversion element 10B illustrated in Fig. 2 in that the porous layer 12 is not provided, but the photoelectric conversion element 10C has the same configuration as that of the photoelectric conversion element 10B except for the difference. That is, in the photoelectric conversion element 10C, the photosensitive layer 13C is formed on the surface of the blocking layer 14 in a thick film shape. In the photoelectric conversion element 10C, the hole transport layer 3B may be provided to be thick in the same manner as in the hole transport layer 3A.

The photoelectric conversion element 10D illustrated in Fig. 4 schematically illustrates still another preferred aspect of the photoelectric conversion element obtained by the manufacturing method of the embodiment of the invention. The photoelectric conversion element 10D is different from the photoelectric conversion element 10C illustrated in Fig. 3 in that an electron transport layer 15 is provided instead of the blocking layer 14, but the photoelectric conversion element 10D has the same configuration as that of the photoelectric conversion element 10C except for the difference. The first electrode 1D includes the conductive support 11, and the electron transport layer 15 and the photosensitive layer 13C which are sequentially formed on the conductive support 11. The photoelectric conversion element 10D is preferable when considering that the respective layers can be formed from an organic material. According to this, the productivity of the photoelectric conversion element is improved, and thickness reduction or flexibilization becomes possible.

The photoelectric conversion element 10E illustrated in Fig. 5 schematically illustrates still another preferred aspect of the photoelectric conversion element obtained by the manufacturing method of the embodiment of the invention. A system 100E including the photoelectric conversion element 10E is a system that is applied to use of a cell in the same manner as in the system 100A.

The photoelectric conversion element 10E includes a first electrode 1E, a second electrode 2, and an electron transport layer 4 that is provided between the first electrode 1E and the second electrode 2. The first electrode 1E includes the conductive support 11, and a hole transport layer 16 and the photosensitive layer 13C which are formed on the conductive support 11 in this order. The photoelectric conversion element 10E is preferable when considering that respective layers can be formed from an organic material in the same manner as in the photoelectric conversion element 10D.

The photoelectric conversion element 10F illustrated in Fig. 6 schematically illustrates still another preferred aspect of the photoelectric conversion element obtained by the manufacturing method of the embodiment of the invention. The photoelectric conversion element 10F is different from the photoelectric conversion element 10B illustrated in Fig. 2 in that the hole transport layer 3B is not provided, but the photoelectric conversion element 10F has the same configuration as that of the photoelectric conversion element 10B except for the difference.

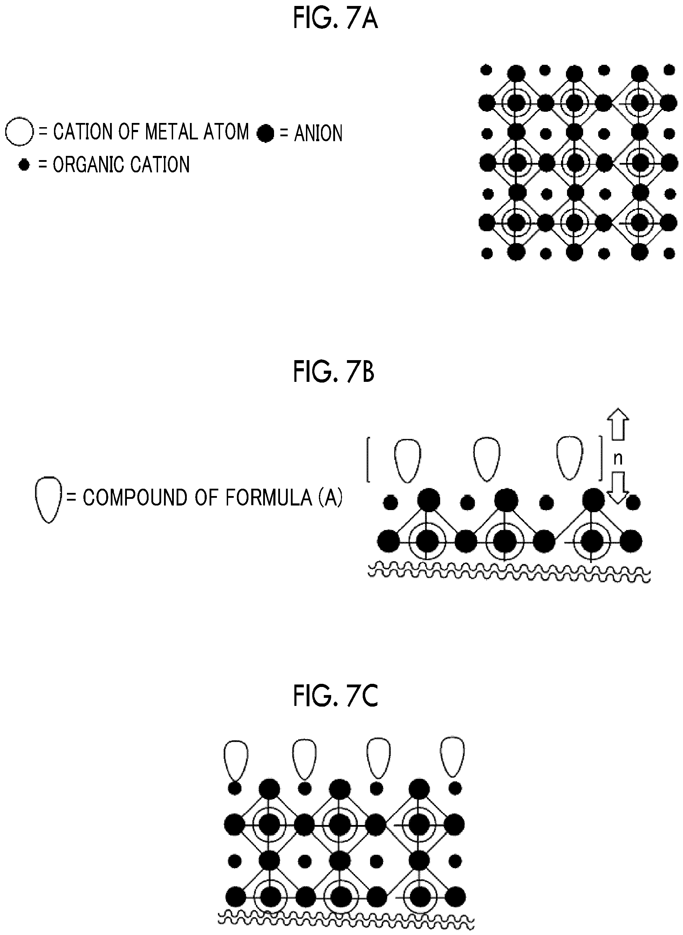

Next, with reference to Figs. 7A to 7E, an aspect of the protective layer provided on the surface of the photosensitive layer will be described in detail.

Fig. 7A is a view schematically illustrating a crystal structure of a perovskite compound contained in the photosensitive layer.

In the present invention, as a form of the protective layer PL in the case where the protective layer PL is provided on the perovskite compound constituting the surface of the photosensitive layer 13, first to third embodiments shown below can be considered.

### (First aspect of protective layer)

Fig. 7B shows a first embodiment of the protective layer PL in the case where the protective layer PL is provided on the perovskite compound which is present on the surface of the photosensitive layer 13. In Fig. 7B, on the surface of the perovskite-type crystal structure, the protective layer PL composed of the compound of Formula (A) is present as a monolayer or as a laminated structure in which a plurality of monolayers are laminated. In Fig. 7B, n represents the number of laminated monolayers.

### (Second aspect of protective layer)

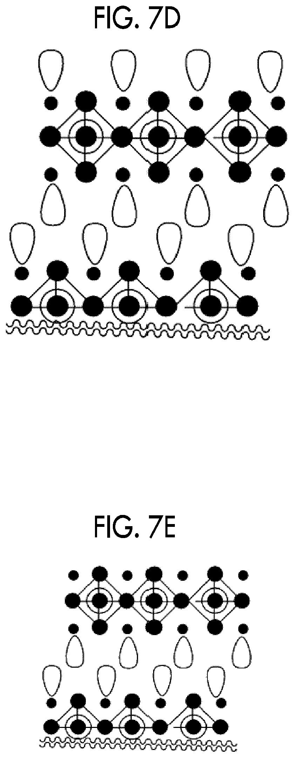

Figs. 7C and 7D show a second embodiment of the protective layer PL in the case where the protective layer PL is provided on the perovskite compound constituting the surface of the photosensitive layer 13. These drawings show a state in which the compound of Formula (A) is bonded to the organic cation of the perovskite-type crystal structure constituting the photosensitive layer 13, thereby by forming the protective layer PL. In this case, a part of the protective layer may penetrate into the crystal structure of the perovskite compound. Fig. 7C shows a state in which the compound of Formula (A) is present only on the surface of the photosensitive layer 13, and Fig. 7D shows a state in which the compound of Formula (A) is present over a certain depth from the surface of the photosensitive layer 13.

In addition, in a state where the protective layer PL is formed by bonding of the compound of Formula (A) to the organic cation of the perovskite-type crystal structure, in a case where the protective layer PL formed of the compound of Formula (A) is sufficiently thin with respect to the photosensitive layer 13, the compound of Formula (A) may not be protruded up to the outermost layer of the protective layer PL as shown in Fig. 7E, and such an aspect is also preferable as the form of the protective layer in the present invention.

Although not shown in the drawing, the second aspect also includes a case where the compound of Formula (A) is not bonded to the organic cation of the perovskite compound, and the compound of Formula (A) is simply mixed with the perovskite compound instead.

### (Third aspect of protective layer)

A third aspect of the protective layer PL is a combination of the first aspect and the second aspect.

In the present invention, a system 100 to which the photoelectric conversion element 10 is applied functions as a solar cell as follows.

Specifically, in the photoelectric conversion element 10, light that is transmitted through the conductive support 11, or the second electrode 2 and is incident to the photosensitive layer 13 excites a light absorbing agent. The excited light absorbing agent includes high-energy electrons and can emit the electrons. The light absorbing agent, which emits high-energy electrons, becomes an oxidized substance (cation).

In the photoelectric conversion elements 10A to 10D and 10F, electrons emitted from the light absorbing agent migrate between a plurality of the light absorbing agents and reach the conductive support 11. The electrons which have reached the conductive support 11 work in the external circuit 6, and then return to the photosensitive layer 13 through the second electrode 2 (and also through the hole transport layer 3 in a case where the hole transport layer 3 is present). The light absorbing agent is reduced by the electrons which have returned to the photosensitive layer 13.

Meanwhile, in the photoelectric conversion element 10E, the electrons which have emitted from the light absorbing agent reaches the second electrode 2 from the photosensitive layer 13C through the electron transport layer 4, work in the external circuit 6, and then return to the photosensitive layer 13 through the conductive support 11. The light absorbing agent is reduced by the electrons which have returned to the photosensitive layer 13.

As described above, in the photoelectric conversion element 10, a cycle of excitation of the light absorbing agent and electron migration is repeated, and thus the system 100 functions as a solar cell.

In the photoelectric conversion elements 10A to 10D and 10F, a method of allowing an electron to flow from the photosensitive layer 13 to the conductive support 11 is different depending on presence or absence of the porous layer 12, a kind thereof, and the like. In the photoelectric conversion element 10 of the embodiment of the invention, electron conduction, in which electrons migrate between the light absorbing agents, occurs. Accordingly, in the present invention, in a case where the porous layer 12 is provided, the porous layer 12 can be formed from an insulating substance other than semiconductors in the related art. In a case where the porous layer 12 is formed from a semiconductor, electron conduction, in which electrons migrate at the inside of semiconductor fine particles of the porous layer 12 or between the semiconductor fine particles, also occurs. On the other hand, in a case where the porous layer 12 is formed from an insulating substance, electron conduction in the porous layer 12 does not occur. In a case where the porous layer 12 is formed from the insulating substance, in a case of using fine particles of an aluminum oxide (Al₂O₃) as the fine particles of the insulating substance, a relatively high electromotive force (V_{OC}) is obtained.

Even in a case where the blocking layer 14 as the other layer is formed from a conductor or a semiconductor, electron conduction in the blocking layer 14 occurs.

In addition, even in the electron transport layer 15, electron conduction occurs.

The photoelectric conversion elements obtained by the manufacturing method of the embodiment of the invention are not limited to the preferred aspects, and configurations and the like of the respective aspects may be appropriately combined between the respective aspects in a range not departing from the gist of the present invention. For example, as the configuration of the photoelectric conversion element 10C or 10D, the hole transport layer 3B may not be provided, as in the photoelectric conversion element 10F.

In the present invention, materials and respective members which are used in the photoelectric conversion element can be prepared by using a typical method except the light absorbing agent. With regard to the photoelectric conversion element formed of the perovskite compound or the solar cell, for example, it is possible to refer to Science, 2012, Vol. 338, p. 643-647; ACS Nano, 2014, Vol. 8, No. 10, p. 9815-9821; and Advanced Functional Materials, 2015, Vol. 25, p. 6875-6884. In addition, it is possible to refer to J. Am. Chem. Soc., 2009, 131 (17), p. 6050-6051 and Science, 338, p. 643 (2012).

In addition, reference can be made to materials and respective members which are used in a dye sensitized solar cell. With regard to dye sensitized solar cells, for example, reference can be made to JP2001-291534A, US4,927,721A, US4,684,537A, US5,084,365A, US5,350,644A, US5,463,057A, US5,525,440A, JP1995-249790A (JP-H7-249790A), JP2004-220974A, and JP2008-135197A.

Hereinafter, preferred aspects of members and compounds that the photoelectric conversion element obtained by the manufacturing method of the embodiment of the invention comprises, will be explained.

### <First electrode 1>

The first electrode 1 includes the conductive support 11 and the photosensitive layer 13, and functions as an operation electrode in the photoelectric conversion element 10.

It is preferable that the first electrode 1 has at least one of the porous layer 12, the blocking layer 14, the electron transport layer 15, or the hole transport layer 16 as illustrated in Figs. 1 to 6.

It is preferable that the first electrode 1 includes at least the blocking layer 14 from the viewpoint of short-circuit prevention, and more preferably the porous layer 12 and the blocking layer 14 from the viewpoints of light absorption efficiency and short-circuit prevention.

In addition, it is preferable that the first electrode 1 includes the electron transport layer 15 and the hole transport layer 16 which are formed from an organic material from the viewpoints of an improvement in productivity of the photoelectric conversion element, thickness reduction, and flexibilization.

### -Conductive support 11-

The conductive support 11 is not particularly limited as long as the conductive support 11 has conductivity and can support the photosensitive layer 13 and the like. It is preferable that the conductive support 11 has a configuration formed from a conductive material, for example, a metal, or a configuration including the support 11a formed from glass or plastic and the transparent electrode 11b formed on a surface of the support 11a as a conductive film.

Among these, as illustrated in Figs. 1 to 6, it is more preferable that the conductive support 11 has a configuration in which a conductive metal oxide is applied to the surface of the support 11a formed from glass or plastic to form the transparent electrode 11b. Examples of the support 11a formed from plastic include a transparent polymer film described in Paragraph 0153 of JP2001-291534A. As a material that forms the support 11a, it is possible to use ceramic (JP2005-135902A) and a conductive resin (JP2001-160425A) in addition to glass or plastic. As a metal oxide, a tin oxide (TO) is preferable, and an indium-tin oxide (a tin-doped indium oxide; ITO) or a fluorine-doped tin oxide such as a tin oxide doped with fluorine (FTO) is particularly preferable. At this time, the amount of the metal oxide applied is preferably 0.1 to 100 g per 1 m² of a surface area of the support 11a. In a case of using the conductive support 11, it is preferable that light is incident from a support 11a side.

It is preferable that the conductive support 11 is substantially transparent. In the present invention, "substantially transparent" represents that transmittance of light (having a wavelength of 300 to 1200 nm) is 10% or greater, preferably 50% or greater, and more preferably 80% or greater.

The thickness of the support 11a and the conductive support 11 is not particularly limited and is set to an appropriate thickness. For example, the thickness is preferably 0.01 µm to 10 mm, more preferably 0.1 µm to 5 mm, and still preferably 0.3 µm to 4 mm.

In a case of providing the transparent electrode 11b, the film thickness of the transparent electrode 11b is not particularly limited. For example, the film thickness is preferably 0.01 to 30 µm, more preferably 0.02 to 25 µm, and still more preferably 0.025 to 20 µm.

The conductive support 11 or the support 11a may have a light management function on the surface. For example, the conductive support 11 or the support 11a may include an antireflection film formed by alternately laminating a high-refractive-index and a low-refractive-index oxide film on the surface of the conductive support 11 or the support 11a as described in JP2003-123859A or may have a light guide function as described in JP2002-260746A.

### -Blocking layer 14-

In the present invention, as in the photoelectric conversion elements 10A to 10C and 10F, the blocking layer 14 is preferably provided on the surface of the transparent electrode 11b, that is, between the conductive support 11, and the porous layer 12, the photosensitive layer 13, the hole transport layer 3, or the like.

In the photoelectric conversion element, for example, in a case where the photosensitive layer 13 or the hole transport layer 3, and the transparent electrode 11b and the like are electrically connected to each other, a reverse current is generated. The blocking layer 14 plays a role of preventing the reverse current. The blocking layer 14 is also referred to as a "short-circuit prevention layer."

The blocking layer 14 may be allowed to function as a stage that carries the light absorbing agent.

The blocking layer 14 may be provided even in a case where the photoelectric conversion element includes the electron transport layer. For example, in a case of the photoelectric conversion element 10D, the blocking layer 14 may be provided between the conductive support 11 and the electron transport layer 15, and in a case of the photoelectric conversion element 10E, the blocking layer 14 may be provided between the second electrode 2 and the electron transport layer 4.

The material that forms the blocking layer 14 is not particularly limited as long as the material can perform the above-described function, and it is preferable that the material is a material through which visible light is transmitted, and which has insulating properties with respect to the conductive support 11 (transparent electrode 11b) and the like. Specifically, "material having insulating properties with respect to the conductive support 11 (transparent electrode 11b)" represents a compound (n-type semiconductor compound) having a conduction band energy level that is equal to or higher than a conduction band energy level of a material that forms the conductive support 11 (a metal oxide that forms the transparent electrode 11b) and is lower than a conduction band energy level of a material that constitutes the porous layer 12 or a ground state energy level of the light absorbing agent.

Examples of a material that forms the blocking layer 14 include silicon oxide, magnesium oxide, aluminum oxide, calcium carbonate, cesium carbonate, polyvinyl alcohol, polyurethane, and the like. In addition, the material may be a material that is typically used as a photoelectric conversion material, and examples thereof include titanium oxide, tin oxide, zinc oxide, niobium oxide, tungsten oxide, and the like. Among these, titanium oxide, tin oxide, magnesium oxide, aluminum oxide, and the like are preferred.

It is preferable that the film thickness of the blocking layer 14 is 0.001 to 10 µm, more preferably 0.005 to 1 µm, and still more preferably 0.01 to 0.1 µm.

In the present invention, the film thickness of each layer can be measured by observing the cross section of the photoelectric conversion element 10 using a scanning electron microscope (SEM) and the like.

### -Porous layer 12-

In the present invention, as in the photoelectric conversion elements 10A, 10B, and 10F, the porous layer 12 is preferably provided on the transparent electrode 11b. In a case where the blocking layer 14 is provided, the porous layer 12 is preferably formed on the blocking layer 14.

The porous layer 12 is a layer that functions as a stage that carries the photosensitive layer 13 on the surface. In a solar cell, so as to increase the light absorption efficiency, it is preferable to increase a surface area of at least a portion that receives light such as solar light, and it is preferable to increase the surface area of the porous layer 12 as a whole.

It is preferable that the porous layer 12 is a fine particle layer that includes pores and is formed through vapor-deposition or close contact of fine particles of a material that forms the porous layer 12. The porous layer 12 may be a fine particle layer that is formed through vapor-deposition of two or more kinds of fine particles. In a case where the porous layer 12 is a fine particle layer that includes pores, it is possible to increase the amount (adsorption amount) of the carried light absorbing agent.

It is preferable to increase the surface area of individual fine particles which constitute the porous layer 12 so as to increase the surface area of the porous layer 12. In the present invention, in a state in which the fine particles are applied to the conductive support 11 and the like, it is preferable that the surface area of the fine particles which form the porous layer 12 is 10 or more times a projected area, and more preferably 100 or more times the projected area. The upper limit thereof is not particularly limited. Typically, the upper limit is approximately 5000 times the projected area. With regard to a particle size of the fine particles which form the porous layer 12, an average particle size, which uses a diameter when converting the projected area into a circle, is preferably 0.001 to 1 µm as primary particles. In a case where the porous layer 12 is formed by using a dispersion of fine particles, the average particle size of the fine particles is preferably 0.01 to 100 µm in terms of an average particle size of the dispersion.

For the material that forms the porous layer 12, there is no particular limitation with respect to conductivity. The material may be an insulating substance (insulating material), a conductive material, or a semiconductor (semi-conductive material).

As the material that forms the porous layer 12, it is possible to use, for example, chalcogenides (for example, an oxide, a sulfide, a selenide, and the like) of metals, compounds having a perovskite-type crystal structure (excluding a perovskite compound that uses a light absorbing agent), oxides of silicon (for example, silicon dioxide, and zeolite), or carbon nanotubes (including carbon nanowires, carbon nanorods, and the like).

The chalcogenides of a metal are not particularly limited, and preferred examples thereof include respective oxides of titanium, tin, zinc, tungsten, zirconium, hafnium, strontium, indium, cerium, yttrium, lanthanum, vanadium, niobium, aluminum, and tantalum, cadmium sulfide, cadmium selenide, and the like. Examples of the crystal structure of the chalcogenides of metals include an anatase-type crystal structure, a brookite-type crystal structure, and a rutile-type crystal structure, and the anatase-type crystal structure and the brookite-type crystal structure are preferable.

The compound having a perovskite-type crystal structure is not particularly limited, and examples thereof include a transition metal oxide and the like. Examples of the transition metal oxide include strontium titanate, calcium titanate, barium titanate, lead titanate, barium zirconate, barium stannate, lead zirconate, strontium zirconate, strontium tantalate, potassium niobate, bismuth ferrate, barium strontium titanate, lanthanum barium titanate, calcium titanate, sodium titanate, and bismuth titanate. Among these, strontium titanate, calcium titanate, and the like are preferable.

The carbon nanotubes have a shape obtained by rounding off a carbon film (graphene sheet) into a tubular shape. The carbon nanotubes are classified into a single-walled carbon nanotube (SWCNT) obtained by winding one graphene sheet in a cylindrical shape, a double-walled carbon nanotube (DWCNT) obtained by winding two graphene sheets in a concentric shape, and a multi-walled carbon nanotube (MWCNT) obtained by winding a plurality of graphene sheets in a concentric shape. As the porous layer 12, any carbon nanotubes can be used without any particular limitation.

Among these, as the material that forms the porous layer 12, an oxide of titanium, tin, zinc, zirconium, aluminum, or silicon, or a carbon nanotube is preferable, and titanium oxide or aluminum oxide is more preferable.

The porous layer 12 may be formed from at least one kind of the chalcogenides of metals, the compound having a perovskite-type crystal structure, the oxide of silicon, or the carbon nanotube, or may be formed from a plurality of kinds thereof.

The film thickness of the porous layer 12 is not particularly limited. The thickness is typically in a range of 0.05 to 100 µm, and preferably in a range of 0.1 to 100 µm. In a case of being used as a solar cell, the film thickness is preferably 0.1 to 50 µm, and more preferably 0.2 to 30 µm.

### -Electron transport layer 15-

In the present invention, as in the photoelectric conversion element 10D, the electron transport layer 15 is preferably provided on the surface of the transparent electrode 11b.

The electron transport layer 15 has a function of transporting electrons, which are generated in the photosensitive layer 13, to the conductive support 11. The electron transport layer 15 is formed from an electron transporting material capable of exhibiting the above-described function. The electron transporting material is not particularly limited, and an organic material (organic electron transporting material) is preferable. Examples of the organic electron transporting material include fullerene compounds such as [6,6]-phenyl-C61-butyric acid methyl ester (PC₆₁BM), perylene compounds such as perylene tetracarboxylic diimide (PTCDI), low-molecular-weight compounds such as tetracyanoquinodimethane (TCNQ), high-molecular-weight compounds, or the like.

Although not particularly limited, it is preferable that the film thickness of the electron transport layer 15 is 0.001 to 10 µm, and more preferably 0.01 to 1 µm.

### -Hole transport layer 16-

In the present invention, as in the photoelectric conversion element 10E, the hole transport layer 16 is preferably provided on the surface of the transparent electrode 11b.

The hole transport layer 16 is the same as the hole transport layer 3 to be described later except for a different formation position.

### -Photosensitive layer (light absorbing layer) 13-

The photosensitive layer 13 is preferably provided on the surface (including an inner surface of a concave portion in a case where a surface on which the photosensitive layer 13 is provided is uneven) of each of the porous layer 12 (in the photoelectric conversion elements 10A, 10B, and 10F), the blocking layer 14 (in the photoelectric conversion element IOC), the electron transport layer 15 (in the photoelectric conversion element 10D), and the hole transport layer 16 (in the photoelectric conversion element 10E).

In the present invention, the light absorbing agent is contained in the photosensitive layer 13. The light absorbing agent contains the organic cation, the cation of the metal atom, and the anion. At least a part of the light absorbing agent has the perovskite-type crystal structure.

In addition, the photosensitive layer may have a light absorbing component such as a metal complex dye and an organic dye in addition to the above light absorbing agent.

The photosensitive layer 13 may be a monolayer or a laminated layer of two or more layers. In a case where the photosensitive layer 13 has the laminated layer structure of two or more layers, the laminated layer structure may be a laminated layer structure obtained by laminating layers formed from light absorbing agents different from each other, or a laminated layer structure including an interlayer including a hole transporting material between a photosensitive layer and a photosensitive layer. In a case where the photosensitive layer 13 has the laminated layer structure of two or more layers, it is sufficient that at least one layer has the perovskite compound, in at least one layer of the layers having the perovskite compound, at least a part of the surface side of the second electrode is covered by the protective layer PL. The photosensitive layer 13 is preferably a mono-layered structure.

The aspect in which the photosensitive layer 13 is provided on the conductive support 11 is as described above. The photosensitive layer 13 is preferably provided on a surface of each of the layers in order for an excited electron to flow to the conductive support 11 or the second electrode 2. At this time, the photosensitive layer 13 may be provided on the entirety or a part of the surface of each of the layers.

The film thickness of the photosensitive layer 13 is appropriately set in correspondence with an aspect in which the photosensitive layer 13 is provided on the conductive support 11, and is not particularly limited. In general, for example, the film thickness is preferably 0.001 to 100 µm, more preferably 0.01 to 10 µm, and still more preferably 0.01 to 5 µm.

In a case where the porous layer 12 is provided, a total film thickness including the film thickness of the porous layer 12 is preferably 0.01 µm or greater, more preferably 0.05 µm or greater, still more preferably 0.1 µm or greater, and still more preferably 0.3 µm or greater. In addition, the total film thickness is preferably 100 µm or less, more preferably 50 µm or less, and still more preferably 30 µm or less. The total film thickness may be set to a range in which the above-described values are appropriately combined. Here, as illustrated in Fig. 1, in a case where the photosensitive layer 13 has a thin film shape, the film thickness of the photosensitive layer 13 represents a distance between an interface with the porous layer 12, and an interface with the protective layer PL to be described later along a direction that is perpendicular to the surface of the porous layer 12.

In a case where the photoelectric conversion element 10 includes the porous layer 12 and the hole transport layer 3, a total film thickness of the porous layer 12, the photosensitive layer 13, the protective layer PL, and the hole transport layer 3 is not particularly limited. For example, the total thickness is preferably 0.01 µm or greater, more preferably 0.05 µm or greater, still more preferably 0.1 µm or greater, and still more preferably 0.3 µm or greater. In addition, the total film thickness is preferably 200 µm or less, more preferably 50 µm or less, even more preferably 30 µm or less, and particularly preferably 5 µm or less. The total film thickness may be set to a range in which the above-described values are appropriately combined.

In the present invention, in a case where the photosensitive layer is provided in a thick film shape (in the photosensitive layer 13B and 13C), the light absorbing agent that is included in the photosensitive layer may function as a hole transporting material.

### [Light absorbing agent]

In the photoelectric conversion element of the embodiment of the invention, a light absorbing agent constituting the photosensitive layer has an organic cation, a cation of a metal atom, and an anionic atom or an anion of an anionic atomic group, and at least a part of the light absorbing agent has the perovskite-type crystal structure.

As the organic cations constituting the light absorbing agent, one or two or more organic cations represented by Formula (I) can be used.

Formula (I) R¹-NR^{1a}₃⁺

In Formula (I), R¹ is more preferably an alkyl group, a cycloalkyl group, an alkenyl group, an alkynyl group, an aryl group, a heteroaryl group, an aliphatic heterocyclic group, or a group represented by Formula (Ia), even more preferably an alkyl group or a group represented by Formula (Ia), and particularly preferably methyl, ethyl, or a group represented by Formula (Ia).

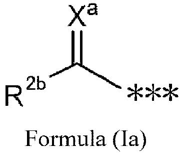

In the group represented by Formula (Ia), X^{a} represents NR^{2c}, an oxygen atom, or a sulfur atom, and NR^{2c} is preferable. R^{2c} represents a hydrogen atom or a substituent. A substituent which can be taken as R^{2c} is not particularly limited, but the alkyl group, the cycloalkyl group, the alkenyl group, the alkynyl group, the aryl group, the heteroaryl group, or the aliphatic heterocyclic group is preferable. R^{2c} is preferably a hydrogen atom.

R^{2b} represents a hydrogen atom or a substituent, and is preferably a hydrogen atom. A substituent which can be taken as R^{2b} is not particularly limited, and examples thereof include the amino group, the alkyl group, the cycloalkyl group, the alkenyl group, the alkynyl group, the aryl group, the heteroaryl group, or the aliphatic heterocyclic group.

The alkyl groups which can be taken as R^{2b} and R^{2c} include a linear alkyl group and a branched alkyl group. The number of carbon atoms of the alkyl group is preferably from 1 to 18, more preferably from 1 to 12, even more preferably from 1 to 6, and is particularly preferably from 1 to 3. Preferred specific examples of the alkyl group include methyl, ethyl, propyl, isopropyl, n-butyl, t-butyl, pentyl, hexyl, decyl, and octadecyl.

The cycloalkyl groups which can be taken as R^{2b} and R^{2c} preferably have 3 to 8 carbon atoms. Preferred specific examples of the cycloalkyl group include cyclopropyl, cyclopentyl, and cyclohexyl.

The alkenyl groups which can be taken as R^{2b} and R^{2c} include a linear alkenyl group and a branched alkenyl group. The number of carbon atoms of the alkenyl group is preferably from 2 to 18, more preferably from 2 to 7, and even more preferably from 2 to 5. Preferred specific examples of the alkenyl group include vinyl, allyl, butenyl, pentenyl, and hexenyl.

The alkynyl groups which can be taken as R^{2b} and R^{2c} include a linear alkynyl group and a branched alkynyl group. The number of carbon atoms of the alkynyl group is preferably from 2 to 18, more preferably from 2 to 7, and even more preferably from 2 to 5. Preferable specific examples of the alkynyl group include ethynyl, propynyl, butynyl, pentynyl, hexynyl, and octynyl.

The aryl groups which can be taken as R^{2b} and R^{2c} preferably have 6 to 14 carbon atoms. Preferred specific examples of the aryl group include phenyl and naphthyl, and phenyl is more preferable.

The heteroaryl groups which can be taken as R^{2b} and R^{2c} include a monocyclic group composed of an aromatic hetero ring, and a group composed of a fused hetero ring obtained through condensing of another ring (for example, an aromatic ring, an aliphatic ring, or a hetero ring) with the aromatic hetero ring.

As the ring-constituting heteroatom that constitutes the aromatic hetero ring, a nitrogen atom, an oxygen atom, or a sulfur atom is preferable. In addition, with regard to the number of ring members of the aromatic hetero ring, a 3- to 8-membered ring is preferable, and a 5- or 6-membered ring is more preferable.

Examples of the 5-membered aromatic hetero ring include a pyrrole ring, an imidazole ring, a pyrazole ring, an oxazole ring, a thiazole ring, a triazole ring, a furan ring, and a thiophene ring. In addition, examples of the fused hetero ring containing a 5-membered aromatic hetero ring include a benzimidazole ring, a benzoxazole ring, a benzothiazole ring, an indoline ring, and an indazole ring.

In addition, examples of the 6-membered aromatic hetero ring include a pyridine ring, a pyrimidine ring, a pyrazine ring, and a triazine ring. In addition, examples of the fused hetero ring containing a 6-membered aromatic hetero ring include a quinoline ring and a quinazoline ring.

The aliphatic heterocyclic groups which can be taken as R^{2b} and R^{2c} include a monocyclic group composed of an aliphatic hetero ring alone, and a group composed of a fused aliphatic hetero ring obtained through condensing of another ring (for example, an aliphatic ring) with the aliphatic hetero ring. As the ring-constituting heteroatom that constitutes the aliphatic hetero ring, a nitrogen atom, an oxygen atom, or a sulfur atom is preferable. In addition, with regard to the number of ring members of the aliphatic hetero ring, three-membered to eight-membered rings are preferable, and a five-membered ring or a six-membered ring is more preferable. The number of carbon atoms of the aliphatic hetero ring is preferably from 0 to 24, more preferably from 1 to 18, even more preferably from 2 to 10, and particularly preferably from 3 to 5.

Specific preferred examples of the aliphatic hetero ring include a pyrrolidine ring, an oxolane ring, a thiolane ring, a piperidine ring, a tetrahydrofuran ring, an oxane ring (tetrahydropyran ring), a thiane ring, a piperazine ring, a morpholine ring, a quinuclidine ring, an azetidine ring, an oxetane ring, an aziridine ring, a dioxane ring, a pentamethylene sulfide ring, γ-butyrolactone, and the like.

Preferred aspects of the alkyl group, the cycloalkyl group, the alkenyl group, the alkynyl group, the aryl group, the heteroaryl group, and the aliphatic heterocyclic group which can be taken as R¹ are respectively the same as the preferred aspects of the alkyl group, the cycloalkyl group, the alkenyl group, the alkynyl group, the aryl group, the heteroaryl group, and the aliphatic heterocyclic group which can be taken as R^{2b} to be described later.

Examples of the group represented by Formula (Ia) include a (thio)acyl group, a (thio)carbamoyl group, an imidoyl group, and an amidino group.

Examples of the (thio)acyl group include an acyl group and a thioacyl group. The acyl group is preferably an acyl group having a total of 1 to 7 carbon atoms, and examples thereof include formyl, acetyl (CH₃C(=O)-), propionyl, hexanoyl, and the like. The thioacyl group is preferably a thioacyl group having a total of 1 to 7 carbon atoms, and examples thereof include thioformyl, thioacetyl (CH₃C(=S)-), thiopropionyl, and the like.

Examples of the (thio)carbamoyl group include a carbamoyl group (H₂NC(=O)-) and a thiocarbamoyl group (H₂NC(=S)-).

The imidoyl group is a group represented by R^{2b}-C(=NR^{2c})-. It is preferable that R^{2b} and R^{2c} are respectively a hydrogen atom or an alkyl group, and this alkyl group is the same as the alkyl group which can be taken as the above-described R^{1a}. Examples of the imidoyl group include formimidoyl (HC(=NH)-), acetimidoyl (CH₃C(=NH)-), propionimidoyl (CH₃CH₂C(=NH)-), and the like. Among these, formimidoyl is preferable.

The amidino group as the group represented by Formula (Ia) has a structure (-C(=NH)NH₂) in which R^{2b} of the imidoyl group is an amino group and R^{2c} is a hydrogen atom.

*** represents a binding site with a nitrogen atom in Formula (I).

In Formula (I), R^{1a} represents a hydrogen atom, an alkyl group, a cycloalkyl group, an alkenyl group, an alkynyl group, an aryl group, a heteroaryl group, or an aliphatic heterocyclic group.

Preferred aspects of the alkyl group, the cycloalkyl group, the alkenyl group, the alkynyl group, the aryl group, the heteroaryl group, and the aliphatic heterocyclic group which can be taken as R^{1a} are respectively the same as the preferred aspects of the alkyl group, the cycloalkyl group, the alkenyl group, the alkynyl group, the aryl group, the heteroaryl group, and the aliphatic heterocyclic group which can be taken as R^{2b} to be described later. Two R^{1a}'s adjacent to each other which are linked to a nitrogen atom may form a ring by being linked to each other. In this case, the formed ring may have a heteroatom as a ring-constituting atom.

R^{1a} is preferably a hydrogen atom or an alkyl group and is more preferably a hydrogen atom.

In Formula (I), in a case where all three R^{1a}'s are hydrogen atoms, the compound represented by Formula (I) has a structure in which R¹ and NH₃ in Formula (I) are bonded to have an organic ammonium cation. In a case where the organic ammonium cation can employ a resonance structure, a cation having the resonance structure can be further contained in addition to the organic ammonium cation. For example, in a case where X^{a} is NH (R^{2c} is a hydrogen atom) in the group that can be represented by Formula (Ia), as the structure of the moiety represented by R¹-NR^{1a}₃ in Formula (I), in addition to the organic ammonium cation structure, a structure of an organic amidinium cation which is one of resonance structures of this organic ammonium cation can also be adopted. Examples of the organic amidinium cation include a cation represented by Formula (A^{am}). In the present specification, a form of a resonance structure such as a cation represented by Formula (A^{am}) is also included in the group represented by Formula (Ia).

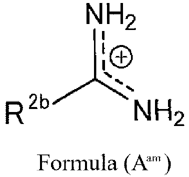

In the perovskite compound constituting the light absorbing agent in the present invention, the cation of the metal atom is preferably a cation of a metal atom other than the elements of Group 1 in the periodic table. Examples of the metal atom include metal atoms such as calcium (Ca), strontium (Sr), cadmium (Cd), copper (Cu), nickel (Ni), manganese (Mn), iron (Fe), cobalt (Co), palladium (Pd), germanium (Ge), tin (Sn), lead (Pb), ytterbium (Yb), europium (Eu), indium (In), titanium (Ti), bismuth (Bi), and thallium (T1). Among them, a Pb atom, a Cu atom, a Ge atom, or a Sn atom is particularly preferable.

The cation of the metal atom may be one kind of cation or may be two or more kinds of cations. In a case of two or more kinds of cations, a proportion (ratio of contents) therebetween is not particularly limited.

In the perovskite compound that is used in the present invention, the anion represents an anion of an anionic atom or atomic group. Preferred examples of the anion include anions of halogen atoms, and anions of individual atomic groups of NCS⁻, NCO⁻, OH⁻, NO₃⁻, CH₃COO⁻, or HCOO⁻. Among these, the anions of halogen atoms are more preferable. Examples of the halogen atoms include a fluorine atom, a chlorine atom, a bromine atom, an iodine atom, and the like.

The X anion may be an anion of one kind of anionic atom or atomic group, or anions of two or more kinds of anionic atoms or atomic groups. In a case where the anion X is an anion of one kind of anionic atom or atomic group, an anion of an iodine atom is preferable. On the other hand, in a case where the anion X includes anions of two or more kinds of anionic atoms or atomic groups, anions of two kinds of halogen atoms, particularly, an anion of a chlorine atom and an anion of an iodine atom are preferable. The proportion (ratio of contents) between two or more kinds of anions is not particularly limited.

In the photoelectric conversion element of the embodiment of the invention, the perovskite compound constituting at least a part of the light absorbing agent is represented by Formula (i), for example.

Formula (i) AₐMₘXₓ

In Formula, A represents a cationic organic group. M represents a metal atom. X represents an anionic atom or an anionic atomic group.
a represents 1 or 2, m represents 1, and a, m, and x satisfy a relationship of a+2m = x.

In Formula (i), the cationic organic group A is present as the organic cation in the perovskite-type crystal structure.

The metal atom M is a metal atom that is present as the above-described cation of the metal atom in the perovskite-type crystal structure.

The anionic atom or an anionic atomic group X is present as the above-described anion in the perovskite-type crystal structure.

The perovskite compound represented by Formula (i) is a perovskite compound represented by the following Formula (i-1) in a case where a is 1, or a perovskite compound represented by the following Formula (i-2) in a case where a is 2.

Formula (i-1) AMX₃

Formula (i-2) A₂MX₄

The crystal structure of the perovskite compound may further contain the cations of the elements of Group 1 in the periodic table.

The cation of the element of Group 1 in the periodic table is not particularly limited, and examples thereof include cations (Li⁺, Na⁺, K⁺, and Cs⁺) of individual elements of lithium (Li), sodium (Na), potassium (K), and cesium (Cs), and the cation (Cs⁺) of cesium is more preferable.

In general, the perovskite compound can be synthesized from a compound represented by the following Formula (ii) and a compound represented by the following Formula (iii).

Formula (ii) AX

Formula (iii) MX₂

A, M, and X in Formulas (ii) and (iii) are respectively the same as A, M, and X in Formula (i).

Examples of the method for synthesizing the perovskite compound include Science, 2012, Vol. 338, p. 643-647; ACS Nano, 2014, Vol. 8, No. 10, p. 9815-9821; and Advanced Functional Materials, 2015, Vol. 25, p. 6875-6884. Examples thereof further include Akihiro Kojima, Kenjiro Teshima, Yasuo Shirai, and Tsutomu Miyasaka, "Organometal Halide Perovskites as Visible-Light Sensitizers for Photovoltaic Cells", J. Am. Chem. Soc., 2009, 131(17), p. 6050 to 6051. In the present specification, the term "perovskite compound" is used to include all crystal structures that can be formed using the AX of Formula (ii) and the MX₂ of Formula (iii).

The amount of the light absorbing agent used is preferably set to an amount capable of covering at least a part of the surface of the first electrode 1, and more preferably an amount capable of covering the entirety of the surface.

The amount of the light absorbing agent contained in the photosensitive layer 13 is typically 1% to 100% by mass.

### <Protective layer PL>

The photoelectric conversion element of the embodiment of the invention includes the protective layer PL on the surface side of the second electrode of the photosensitive layer. The protective layer PL has the compound represented by Formula (A). The compound of Formula (A) has a molecular weight of 5000 or less (preferably a molecular weight of 40 to 4000, and more preferably a molecular weight of 40 to 3000). It is preferable that the compound of Formula (A) be not a polymer (that is, not a compound which can be obtained by polymerization or crosslinking of two or more monomers).

Formula (A) R^{A}-Z

In the formula, R^{A} represents an alkyl group, an alkenyl group, an alkynyl group, a cycloalkyl group, an aryl group, a heteroaryl group, or an aliphatic heterocyclic group. Provided that R^{A} does not have a silyl group as a substituent.

In a case where R^{A} is an alkyl group, it is preferable that the alkyl group is in an unsubstituted form or has a halogen atom, a cycloalkyl group, and/or an aryl group as a substituent.

In a case where R^{A} is an alkenyl group or an alkynyl group, it is preferable that the alkenyl group and the alkynyl group are in an unsubstituted form or have a halogen atom, an 1-alkenyl group, an 1-alkynyl group, a cycloalkyl group, and/or an aryl group as a substituent.

In a case where R^{A} is a cycloalkyl group, an aryl group, a heteroaryl group, or an aliphatic heterocyclic group, it is preferable that the cycloalkyl group, the aryl group, the heteroaryl group, and the aliphatic heterocyclic group are in an unsubstituted form or have a halogen atom, an alkyl group, an alkenyl group, an alkynyl group, a cycloalkyl group, and/or an aryl group as a substituent.

The halogen atom as the substituent that the above R^{A} may have is, for example, a fluorine atom, a chlorine atom, a bromine atom, or an iodine atom, and a fluorine atom is preferable.

The alkyl group, the alkenyl group, and the alkynyl group which can be taken as R^{A} may be linear or branched. The number of carbon atoms of the alkyl group, the alkenyl group, and the alkynyl group is preferably 4 to 30, more preferably 7 to 30, even more preferably 7 to 25, particularly preferably 7 to 20.

The number of carbon atoms of the cycloalkyl group which can be taken as R^{A} is preferably 3 to 30, more preferably 5 to 20, and even more preferably 6 to 15. Preferred specific examples of the cycloalkyl group include cyclopropyl, cyclopentyl, and cyclohexyl.

The number of carbon atoms of the aryl group which can be taken as R^{A} is preferably 6 to 30, more preferably 6 to 20, and even more preferably 6 to 15. Preferred specific examples of the aryl group include phenyl and naphthyl, and phenyl is more preferable.

Preferred aspects of the heteroaryl group and the aliphatic heterocyclic group which can be taken as R^{A} are the same as the preferred aspects of the heteroaryl group and the aliphatic heterocyclic group which can be taken as the above-described R^{2b}. In addition, the number of carbon atoms of the heteroaryl group and the aliphatic heterocyclic group which can be taken as R^{A} is preferably 3 to 30, preferably 4 to 20, and preferably 4 to 15.

In a case where R^{A} contains a ring structure, the number of ring structures is preferably from 1 to 3, more preferably 1 or 2, and even more preferably 1. This ring structure is preferably a 5-membered ring or 6-membered ring.

It is preferable that R^{A} is an alkyl group having 7 to 30 carbon atoms, or a cycloalkyl group or an aryl group.

In addition, in a case where R^{A} is a group other than the alkyl group, the number of carbon atoms of R^{A} is preferably within a range of 7 to 30.

R^{A} is more preferably represented by Formula (r1). 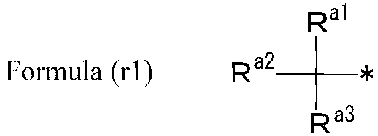 In Formula (r1), R^{a1} and R^{a2} represent a halogen atom, an alkyl group, an alkenyl group, an alkynyl group, a cycloalkyl group, or an aryl group. R^{a3} represents a hydrogen atom, a halogen atom, an alkyl group, an alkenyl group, an alkynyl group, a cycloalkyl group, or an aryl group. * represents a binding site with Z.

It is preferable that not all of R^{a1}, R^{a2}, and R^{a3} are an atom selected from a halogen atom and a hydrogen atom. That is, it is preferable that at least one of R^{a1}, R^{a2}, and R^{a3} is an alkyl group, an alkenyl group, an alkynyl group, a cycloalkyl group, or an aryl group.

The number of carbon atoms of the entirety of the structure represented by Formula (r1) is preferably 7 to 30, more preferably 7 to 25, and even more preferably 7 to 20. In addition, halogen atoms which can be taken as R^{a1}, R^{a2}, and R^{a3} are preferably a fluorine atom.

In Formula (A), Z represents an acidic group or a salt thereof. In the present invention, the term "acidic group" is a group having a dissociative proton.

Examples of the acidic group include -COOH, -SO₃H, -P(=O)(OH)₂, -OP(=O)(OH)₂, -P(=O)R^{X}(OH), -OP(=O)R^{X}(OH), -P(=O)(OR^{Y})(OH), -OP(=O)(0R^{Y})(OH), -B(OH)₂, -B(OR^{Y})(OH), -OB(OH)₂, -OB(OR^{Y})(OH), and -C₆H₅(OH). R^{X} represents a substituent, preferably represents an alkyl group (alkyl group preferably having 1 to 25 carbon atoms, more preferably having 1 to 16 carbon atoms), an aryl group (aryl group preferably having 6 to 12 carbon atoms, more preferably having 6 to 10 carbon atoms), a cycloalkyl group (cycloalkyl group preferably having 3 to 7 carbon atoms, more preferably having 3 to 6 carbon atoms), an alkenyl group (alkenyl group preferably having 2 to 16 carbon atoms, more preferably having 3 to 8 carbon atoms), or an alkynyl group (alkynyl group preferably having 2 to 16 carbon atoms, more preferably having 3 to 8 carbon atoms).

In addition, R^{Y} represents a substituent, preferably represents an alkyl group (alkyl group preferably having 1 to 25 carbon atoms, more preferably having 1 to 16 carbon atoms), or an aryl group (aryl group preferably having 6 to 12 carbon atoms, more preferably having 6 to 10 carbon atoms).

In the present invention, the acidic group is preferably -COOH, -SO₃H, and -P(=O)(OH)₂ or -B(OH)₂, more preferably -SO₃Hor -P(=O)(OH)₂, and even more preferably -P(=O)(OH)₂.

In addition, examples of a salt of the acidic group include a salt with an alkali metal such as sodium and potassium; a salt with an alkaline earth metal such as calcium and magnesium; an ammonium salt such as A (cationic organic group) described in Formula (ii) and tetrabutylammonium; and a salt with nitrogen-containing organic base such as trimethylamine, triethylamine, tributylamine, trometamol, pyridine, N,N-dimethylaniline, N-methylpiperidine, N-methylmorpholine, diethylamine, dicyclohexylamine, procaine, dibenzylamine, N-benzyl-β-phenethylamine, and N,N'-dibenzylethylenediamine.

Preferred specific examples of the compounds (compounds 1 to 123) having a molecular weight of 5000 or less represented by Formula (A) are shown below, but the present invention is not limited thereto.

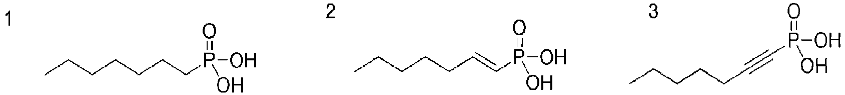

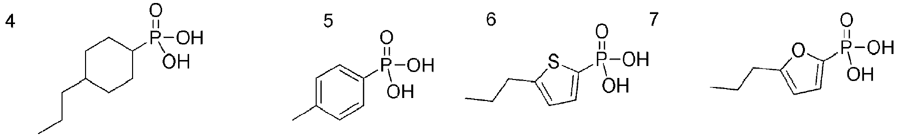

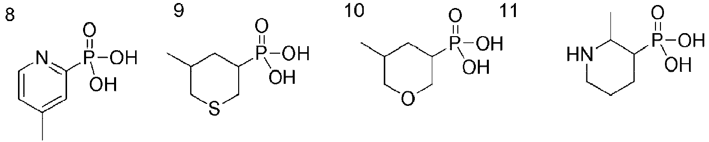

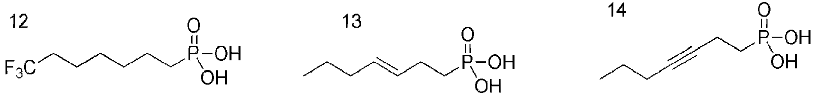

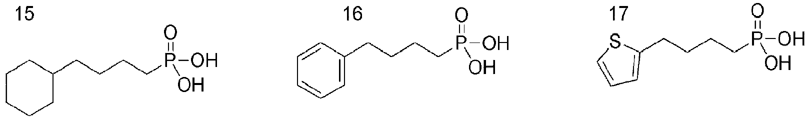

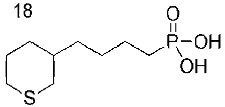

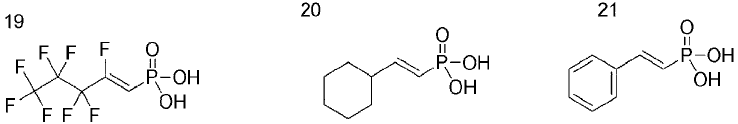

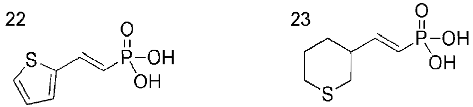

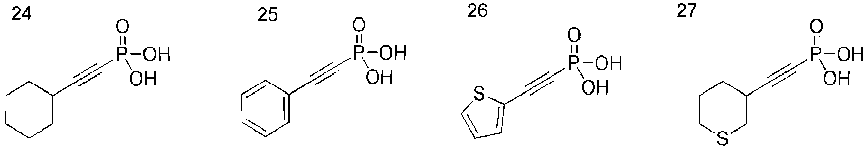

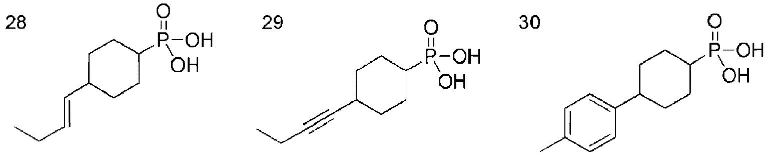

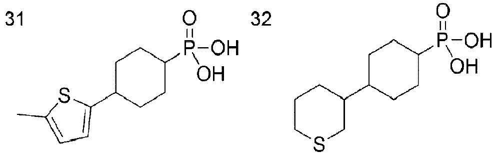

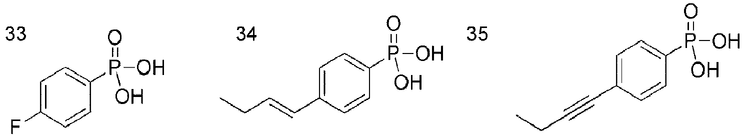

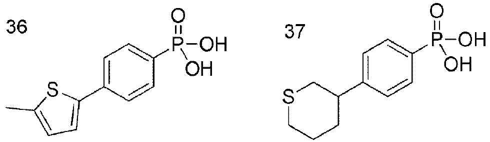

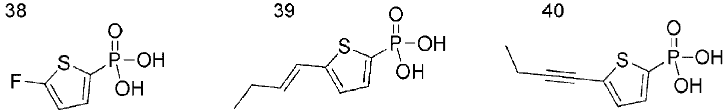

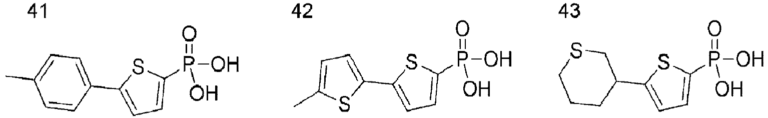

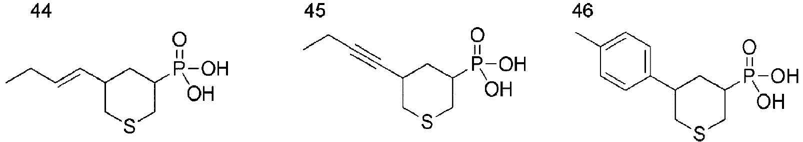

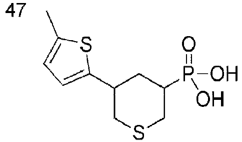

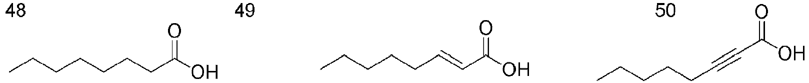

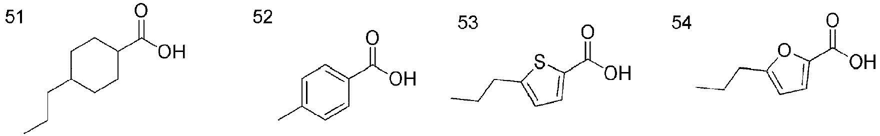

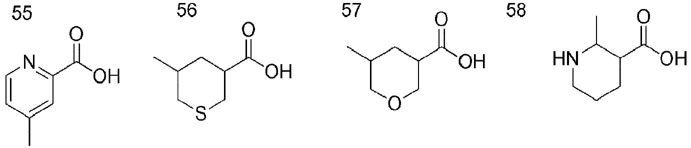

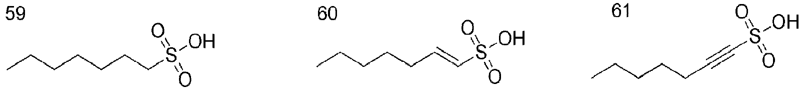

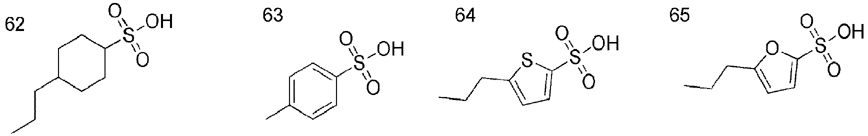

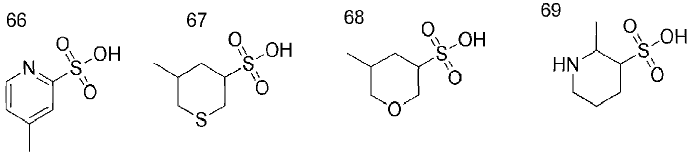

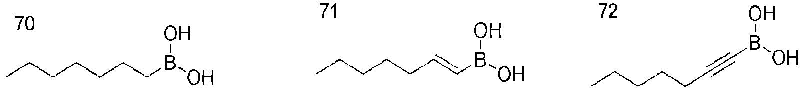

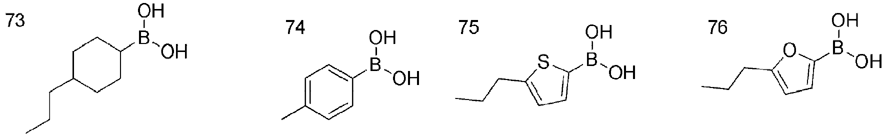

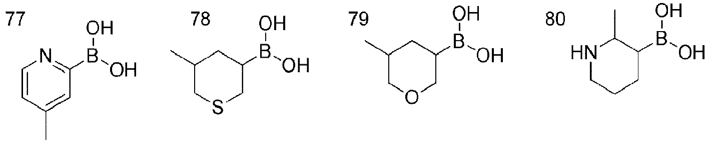

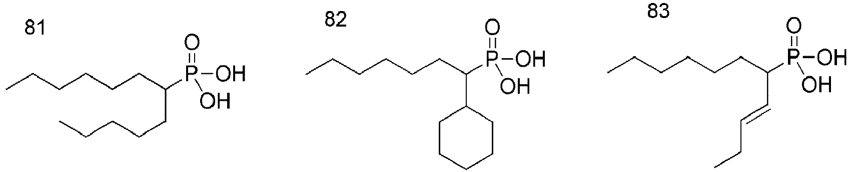

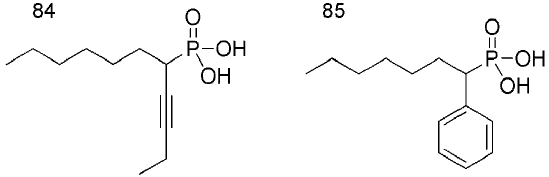

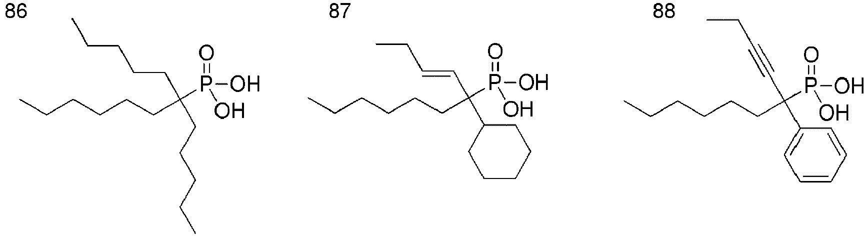

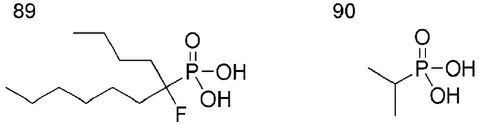

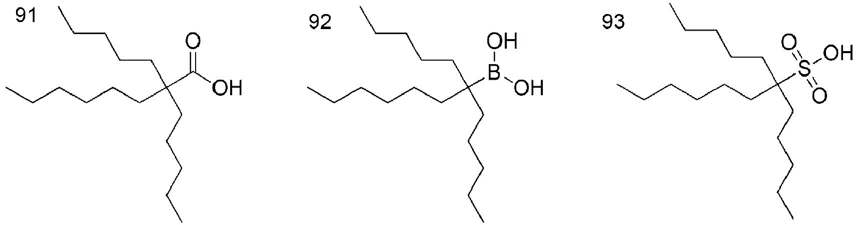

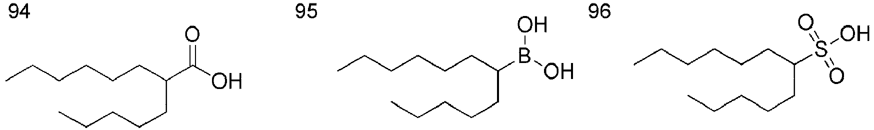

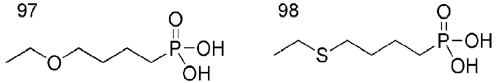

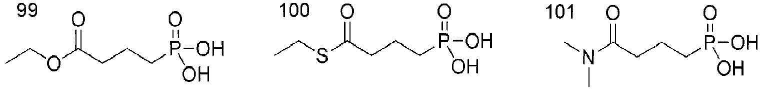

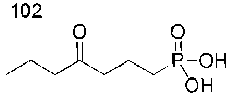

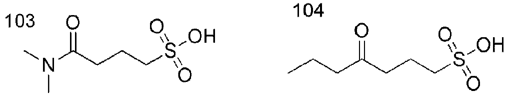

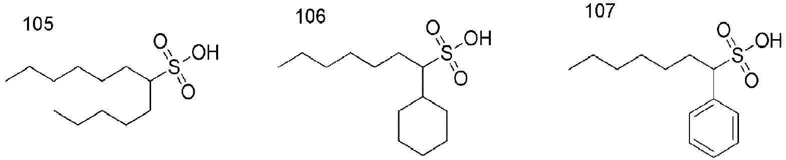

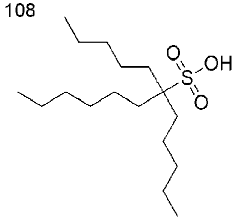

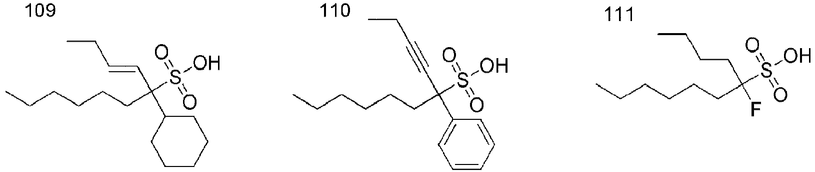

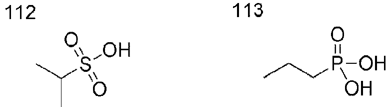

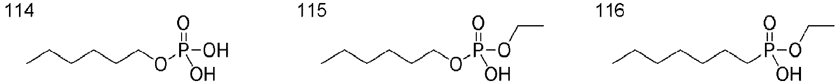

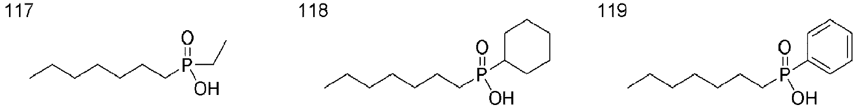

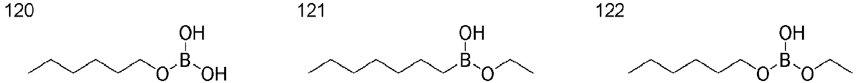

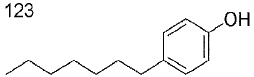

In addition, it is also preferable that the compound having a molecular weight of 5000 or less represented by Formula (A) be in the form of a salt in which the hydrogen atom of the acidic group is replaced by another counter ion in the above-described compounds 1 to 123.

In the photoelectric conversion element using a perovskite compound of the related art as a light absorbing agent, the light absorbing agent is likely to be decomposed by moisture existing outside or inside in advance, and the photoelectric conversion efficiency greatly deteriorates particularly under a high-humidity environment. The reason for this is uncertain, but the condition in which migration of an anion constituting the crystal structure in the photosensitive layer to an adjacent layer (for example, the hole transport layer 3, the electron transport layer 4, or the second electrode 2) is likely to occur due to the influence of moisture, and as a result, defects are generated at the interface between the photosensitive layer and the adjacent layer, moisture becomes more likely to enter the photosensitive layer, and therefore decomposition of the crystal structure in the photosensitive layer proceeds, is perceived as one of the causes.

In the present invention, the protective layer containing the compound having a molecular weight of 5000 or less represented by Formula (A) described above is present on the surface side of the second electrode of the photosensitive layer, whereby it is possible to effectively suppress the damage of the crystal structure in the photosensitive layer under a high-humidity environment. The reason for this is uncertain, but the condition in which this compound is bonded to the organic cation in the crystal structure present on the surface of the photosensitive layer through the acidic group or a salt thereof, and R^{A} is introduced into the crystal structure, is perceived as one of the causes. That is, it is presumed that R^{A} restricts the migration of the anion constituting the crystal structure such that the anion is confined, thereby preventing the migration of the anion to the adjacent layer, and as a result, decomposition of the crystal structure in the photosensitive layer can be effectively suppressed even under a high-humidity environment. In addition, it is also conceivable that the movement of the anions is restricted due to hydrogen-bonding interaction between acidic groups that the above-described compound has or between the acidic group and the anion in the crystal structure present on the surface of the photosensitive layer. By making the structure of R^{A} of the above-described compound bulky, an action of suppressing damage of the crystal structure can be further enhanced.

In the present invention, the term "high-humidity" means, for example, an environment in which a relative humidity is 50% or more.

It is not necessary for the protective layer PL to cover the entire surface on the second electrode side of the photosensitive layer, and film defects may be present within a range that does not impair the effect of the present invention.

In the protective layer PL, a content of the compound represented by Formula (A) is preferably from 5% to 100% by mass, and more preferably from 10% to 100% by mass.

A total thickness of the photosensitive layer 13 and the protective layer PL is preferably from 0.001 to 100 µm, more preferably from 0.01 to 10 µm, and particularly preferably from 0.01 to 5 µm. In addition, in the case of having the porous layer 12, a total thickness of the porous layer 12, the photosensitive layer 13, and the protective layer PL is preferably 0.01 µm or more, more preferably 0.05 µm or more, even more preferably 0.1 µm or more, and particularly preferably 0.3 µm or more. In addition, the total film thickness is preferably 100 µm or less, more preferably 50 µm or less, and even more preferably 30 µm or less.

### <Hole transport layer 3>

In the photoelectric conversion element of the embodiment of the invention, as in the photoelectric conversion elements 10A to 10D, an aspect in which the hole transport layer 3 is provided between the first electrode 1 and the second electrode 2 is also preferable. In the aspect, it is preferable that the hole transport layer 3 is in contact with (laminated on) the photosensitive layer 13 or the protective layer PL. The hole transport layer 3 is preferably provided between the photosensitive layer 13 or the protective layer PL of the first electrode 1 and the second electrode 2.

The hole transport layer 3 includes a function of supplementing electrons to an oxidized substance of the light absorbing agent, and is preferably a solid-shaped layer (solid hole transport layer).

A hole transporting material forming the hole transport layer 3 may be a liquid material or a solid material without any limitation. Examples of the hole transporting material include inorganic materials such as Cul and CuNCS, organic hole transporting materials described in paragraphs 0209 to 0212 of JP2001-291534A, and the like. Preferred examples of the organic hole transporting material include conductive polymers such as polythiophene, polyaniline, polypyrrole, and polysilane, spiro compounds in which two rings share a central atom such as C or Si having a tetrahedral structure, aromatic amine compounds such as triarylamine, triphenylene compounds, nitrogen-containing heterocyclic compounds, and liquid-crystalline cyano compounds.

As the hole transporting material, an organic hole transporting material which can be applied in a solution state and then has a solid shape is preferable, and specific examples thereof include 2,2',7,7'-tetrakis-(N,N-di-p-methoxyphenylamino)-9,9'-spirobifluorene (also referred to as spiro-MeOTAD), poly(3-hexylthiophene-2,5-diyl), 4-(diethylamino)benzaldehyde diphenylhydrazone, polyethylene dioxythiophene (PEDOT), and the like.

Although not particularly limited, the film thickness of the hole transport layer 3 is preferably 50 µm or less, more preferably 1 nm to 10 µm, still more preferably 5 nm to 5 µm, and still more preferably 10 nm to 1 µm. In addition, the film thickness of the hole transport layer 3 corresponds to an average distance between the second electrode 2 and the surface of the photosensitive layer 13, and can be measured by observing a cross-section of the photoelectric conversion element by using a scanning electron microscope (SEM) and the like.

### <Electron transport layer 4>

In the photoelectric conversion element of the embodiment of the invention, as in the photoelectric conversion element 10E, an aspect in which the electron transport layer 4 is provided between the first electrode 1 and the second electrode 2 is also preferable. In the aspect, it is preferable that the electron transport layer 4 is in contact with (laminated on) the photosensitive layer 13 or the protective layer PL.

The electron transport layer 4 is the same as the electron transport layer 15, except that a destination of electrons is the second electrode and positions where the electrons are formed are different.

### <Second electrode 2>

The second electrode 2 functions as a positive electrode in a solar cell. The second electrode 2 is not particularly limited as long as the second electrode 2 has conductivity. Typically, the second electrode 2 can be configured to have the same configuration as that of the conductive support 11. In a case where sufficient strength is maintained, the support 11a is not necessary.

As a structure of the second electrode 2, a structure having a high current-collection effect is preferable. At least one of the conductive support 11 or the second electrode 2 needs to be substantially transparent so that light reaches the photosensitive layer 13. In the solar cell of the embodiment of the invention, it is preferable that the conductive support 11 is transparent and solar light and the like is incident from the support 11a side. In this case, it is more preferable that the second electrode 2 has a light-reflecting property.

Examples of a material used to form the second electrode 2 include metals such as platinum (Pt), gold (Au), nickel (Ni), copper (Cu), silver (Ag), indium (In), ruthenium (Ru), palladium (Pd), rhodium (Rh), iridium (Ir), osmium (Os), and aluminum (Al), the above-described conductive metal oxides, carbon materials, conductive polymers, and the like. The carbon materials may be conductive materials formed through bonding of carbon atoms, and examples thereof include fullerene, a carbon nanotube, graphite, graphene, and the like.

As the second electrode 2, a thin film (including a thin film obtained through vapor-deposition) of a metal or a conductive metal oxide, or a glass substrate or a plastic substrate which has the thin film is preferable. As the glass substrate or the plastic substrate, glass including a gold or platinum thin film or glass on which platinum is vapor-deposited is preferable.

The film thickness of the second electrode 2 is not particularly limited, and is preferably 0.01 to 100 µm, more preferably 0.01 to 10 µm, and still more preferably 0.01 to 1 µm.

### Other configurations>

In the present invention, a spacer or a separator can also be used instead of the blocking layer 14 and the like or in combination with the blocking layer 14 and the like so as to prevent the first electrode 1 and the second electrode 2 from coming into contact with each other.

In addition, a hole blocking layer may be provided between the second electrode 2 and the hole transport layer 3.

### [Solar cell]

The solar cell of the embodiment of the invention is constituted by using the photoelectric conversion element of the embodiment of the invention. For example, as illustrated in Figs. 1 to 6, the photoelectric conversion element 10 having a configuration, which is allowed to operate by the external circuit 6, can be used as the solar cell. As the external circuit 6 that is connected to the first electrode 1 (the conductive support 11) and the second electrode 2, a known circuit can be used without particular limitation.

For example, the present invention is applicable to individual solar cells described in Science, 2012, Vol. 338, p. 643-647; ACS Nano, 2014, Vol. 8, No. 10, p. 9815-9821; and Advanced Functional Materials, 2015, Vol. 25, p. 6875-6884; and J. Am. Chem. Soc., 2009, 131(17), p. 6050 to 6051; and Science, 338, p. 643(2012).

It is preferable that a lateral surface of the solar cell of the embodiment of the invention is sealed with a polymer, an adhesive, and the like so as to prevent deterioration, evaporation, and the like in constituent substances.

### [Method for manufacturing photoelectric conversion element and solar cell]

Other than formation of the protective layer PL, the photoelectric conversion element or the solar cell of the embodiment of the invention can be manufactured in accordance with a known method, for example, a method described in Science, 2012, Vol. 338, p. 643-647; ACS Nano, 2014, Vol. 8, No. 10, p. 9815-9821; and Advanced Functional Materials, 2015, Vol. 25, p. 6875-6884; J. Am. Chem. Soc., 2009, 131(17), p. 6050 to 6051; Science, 338, p. 643(2012); and the like.

Hereinafter, the method of manufacturing the photoelectric conversion element and the solar cell of the embodiment of the invention will be described.

In the manufacture of the photoelectric conversion element of the embodiment of the invention, first, at least one of the blocking layer 14, the porous layer 12, the electron transport layer 15, or the hole transport layer 16 is formed on a surface of the conductive support 11 according to the purpose.

For example, the blocking layer 14 can be formed by a method in which a dispersion, which contains the insulating substance or a precursor compound thereof, and the like, is applied to the surface of the conductive support 11, and the dispersion is baked; a spray pyrolysis method; and the like.

A material that forms the porous layer 12 is preferably used as fine particles, and more preferably a dispersion that contains the fine particles.

A method of forming the porous layer 12 is not particularly limited, and examples thereof include a wet-type method, a dry-type method, and other methods (for example, a method described in Chemical Review, Vol. 110, p. 6595 (published on 2010)). In these methods, it is preferable that the dispersion (paste) is applied to the surface of the conductive support 11 or the surface of the blocking layer 14 and then the dispersion is baked at a temperature 100°C to 800°C for ten minutes to ten hours, for example, in the air. According to this, it is possible to bring the fine particles into close contact with each other.

In a case where baking is performed a plurality of times, a temperature in baking except final baking (a baking temperature except for a final baking temperature) is preferably set to be lower than the temperature in the final baking (the final baking temperature). For example, in a case where titanium oxide paste is used, the baking temperature except for the final baking temperature can be set in a range of 50°C to 300°C. In addition, the final baking temperature can be set in a range of 100°C to 600°C to be higher than the baking temperature except for the final baking temperature. In a case where a glass support is used as the support 11a, the baking temperature is preferably 60°C to 500°C.

The amount of a porous material applied to form the porous layer 12 is appropriately set in correspondence with the film thickness of the porous layer 12, the number of times of coating, and the like, and there is no particular limitation thereto. For example, the amount of the porous material applied per 1 m² of a surface area of the conductive support 11 is preferably 0.5 to 500 g, and more preferably 5 to 100 g.

In a case where the electron transport layer 15 or the hole transport layer 16 is provided, the layer can be formed in the same manner as in the hole transport layer 3 or the electron transport layer 4 to be described below.

### Subsequently, the photosensitive layer 13 is provided.

The photosensitive layer 13 can be formed using a compound capable of synthesizing the perovskite compound by a typical method.

Examples of the compound capable of synthesizing the perovskite compound include the compound AX represented by Formula (ii) and the compound MX₂ represented by Formula (iii). Each of these compounds may be used alone or may be used as a composition (including a form of solution, suspension, paste, and the like).

That is, a preferred embodiment of the method for forming the photosensitive layer 13 is a method in which the photosensitive layer 13 is formed using the light absorbing agent composition containing all of the compounds described above. In addition, in other preferred embodiment, the photosensitive layer 13 is formed using the composition containing the compound AX, and the composition containing the compound MX₂ (these compositions are preferably in a form of solution, suspension, paste, and the like).

In the present invention, as the compound AX, the compound R¹-N(R^{1a})₃X is preferably used. R¹ and R^{1a} are respectively the same as R¹ and R^{1a} in Formula (I), and a preferred aspect thereof is also the same. In the above-described compounds, X is preferably a halogen atom.

Examples of a method of providing the photosensitive layer 13 include a wet-type method and a dry-type method, and there is no particular limitation thereto. In the present invention, a wet-type method is preferable, and for example, a method in which the light absorbing agent composition is brought into contact with the surface of the layer forming the photosensitive layer 13 on the surface thereof (in the photoelectric conversion element 10, any layer of the porous layer 12, the blocking layer 14, the electron transport layer 15, or the hole transport layer 16) can be adopted.

Specifically, as the method in which the light absorbing agent composition is brought into contact with the above surface, applying the light absorbing agent composition on the surface or immersing the composition is preferable. A contact temperature is preferably from 5°C to 100°C, and immersion time is preferably from 5 seconds to 24 hours and more preferably from 20 seconds to 1 hour. In a case of drying the light absorbing agent composition that is applied, with regard to the drying, drying with heat is preferable, and drying is performed by heating the applied light absorbing agent solution typically at 20°C to 300°C, and preferably at 50°C to 170°C.

Still another example of the method includes a dry-type method such as a vacuum deposition by using a mixture from which a solvent of the light absorbing agent composition is removed. For example, a method of simultaneously or sequentially vapor-depositing the compound AX and the compound MX₂ may be exemplified.

According to the methods and the like, the perovskite compound is formed on the surface of the porous layer 12, the blocking layer 14, the electron transport layer 15, or the hole transport layer 16 as the photosensitive layer 13.

On the surface of the photosensitive layer 13 thus formed, the protective layer PL is provided. The protective layer PL is formed by using the compound having a molecular weight of 5000 or less represented by Formula (A) (hereinafter referred to as "compound (A)"). A method for forming the protective layer PL is not particularly limited, and for example, the layers can be formed by bringing a solution containing the compound (A) into contact with the surface of the photosensitive layer. This contact can be carried out by applying the solution containing the compound (A) to the surface of the photosensitive layer 13, or by immersing the surface of the photosensitive layer 13 in the solution. As an application method, various methods to be described later can be adopted.

The solution containing the above-described compound (A) may be either a solution or a suspension (dispersion liquid), but from the viewpoint of forming a more homogeneous layer, it is preferable to use a solution. A content of the compound (A) in this solution is not particularly limited as long as the solution can form the protective layer. From the viewpoint of further enhancing the crystal structure protective action of the formed protective layer, the content of the compound (A) in the solution is preferably from 0.01 to 100 mM, more preferably from 0.1 to 100 mM, and even more preferably from 1 to 100 mM.

In the solution containing the compound (A), as a solvent, an organic solvent is preferable, and a protic solvent and/or an aprotic solvent can be used. As the protic solvent, one or two or more of alcohols, carboxylic acid compounds, sulfonic acid compounds, boric acid compounds, phosphoric acid compounds, phosphonic acid compounds, phosphinic acid compounds, amide compounds, imide compounds, and the like can be used. In addition, examples of the aprotic solvent include chlorobenzene, toluene, hexane, octane, decane, benzene, xylene, diethyl ether, tetrahydrofuran (THF), ethyl acetate, acetone, acetonitrile, N,N-dimethylformamide (DMF), dimethylsulfoxide (DMSO), chloroform, dichloromethane, chlorobenzene, benzyl chloride, and the like. It is preferable to use one or two or more selected from chlorobenzene, toluene, diethyl ether, tetrahydrofuran, chloroform, or dichloromethane.

Among them, from the viewpoint of maintaining the shape of the perovskite film, it is preferable to use the aprotic solvent, and from the viewpoint of the solubility of the compound (A), it is more preferable to use the aprotic solvent and the alcohol in combination. In a case where the aprotic solvent and the alcohol are used in combination, a content of the alcohol in the solvent is preferably from 1% to 50% by mass.

Examples of the above-described alcohol include isopropyl alcohol, methanol, ethanol, t-butanol, ethylene glycol, and the like, and it is preferable to use one or two or more kinds selected from isopropyl alcohol, ethanol, or t-butanol.

A temperature at which the solution containing the compound (A) is brought into contact with the surface of the photosensitive layer is not particularly limited, and may be, for example, from 5°C to 100°C.

After bringing the solution containing the compound (A) into contact with the surface of the photosensitive layer, the layer is preferably subjected to a drying treatment. As a method of the drying treatment, a known method can be applied without particular limitation. A drying temperature can be set to, for example, from 5°C to 300°C, and preferably from 20°C to 150°C. A drying time is also not particularly limited, and is usually from 1 second to 48 hours, preferably from 1 minute to 5 hours.

The hole transport layer 3 or the electron transport layer 4 is preferably formed on the protective layer PL provided as described above.

The hole transport layer 3 can be formed through application and drying of a hole transporting material solution that contains a hole transporting material. In the hole transporting material solution, a concentration of the hole transporting material is preferably 0.1 to 1.0 M (mol/L) when considering that application properties are excellent, and in a case of providing the porous layer 12, the hole transporting material solution easily intrudes into pores of the porous layer 12.

The electron transport layer 4 can be formed through application and drying of an electron transporting material solution that contains an electron transporting material.

After the hole transport layer 3 or the electron transport layer 4 is formed, the second electrode 2 is formed, thereby manufacturing the photoelectric conversion element and the solar cell.

The film thicknesses of the respective layers can be adjusted by appropriately changing the concentrations of respective dispersion liquids or solutions and the number of times of application. For example, in a case where the photosensitive layers 13B and 13C having a large film thickness are provided, a light absorbing agent composition may be applied and dried a plurality of times.

The respective dispersion liquids and solutions described above may respectively contain additives such as a dispersion auxiliary agent and a surfactant as necessary.

Examples of the solvent or dispersion medium that is used in the method of manufacturing the photoelectric conversion element include a solvent described in JP2001-291534A, but the solvent or dispersion medium is not particularly limited thereto. In the present invention, an organic solvent is preferable, and an alcohol solvent, an amide solvent, a nitrile solvent, a hydrocarbon solvent, a lactone solvent, a halogen solvent, and a mixed solvent of two or more kinds thereof are preferable. As the mixed solvent, a mixed solvent of the alcohol solvent and a solvent selected from the amide solvent, the nitrile solvent, and the hydrocarbon solvent is preferable. Specifically, methanol, ethanol, isopropanol, γ-butyrolactone, chlorobenzene, acetonitrile, N,N'-dimethylformamide (DMF), dimethylacetamide, and a mixed solvent thereof are preferable.

A method of applying the solutions or dispersants which form the respective layers is not particularly limited, and it is possible to use a known application method such as spin coating, extrusion die coating, blade coating, bar coating, screen printing, stencil printing, roll coating, curtain coating, spray coating, dip coating, an inkjet printing method, and an immersion method. Among these, a spin coating method, a screen printing method, and the like are preferable.

The photoelectric conversion element of the embodiment of the invention may be subjected to an efficiency stabilizing treatment such as annealing, light soaking, and being left as is in an oxygen atmosphere as necessary.

The photoelectric conversion element prepared as described above can be used as a solar cell after connecting the external circuit 6 to the first electrode 1 and the second electrode 2.

### [Surface treating agent]

The surface treating agent for a perovskite-type crystal film of the embodiment of the invention (hereinafter referred to as "surface treating agent of the present invention") contains the above-described compound (A). By applying the surface treating agent of the embodiment of the invention to the surface of the perovskite-type crystal film, damage to the crystal structure of the perovskite-type crystal film can be suppressed. The term "perovskite-type crystal film" referred herein means a film having a perovskite compound in at least a part of the film. Representative examples of the perovskite-type crystal film include the above-described photosensitive layer 13; however, the present invention is not limited to this aspect. The surface treating agent of the embodiment of the invention can be applied without limitation as long as it is a film having a perovskite compound in at least a part of the film, and exhibits the desired effect.

The surface treating agent of the embodiment of the invention may be the compound (A) itself, or may contain other components in addition to the compound (A). Examples of other components include a solvent, a compound AX (preferably an organic ammonium salt) of Formula (ii), A (an organic amine which is not a cation), BX (B representing a cation of the elements of Group 1 in the periodic table), and the compound MX₂ of Formula (iii) described above. AX, A, BX, and MX₂ may be a mixture of two or more.

The surface treating agent of the embodiment of the invention may be in a form of a composition in which each component containing the compound (A) is mixed homogeneously, or in a form in which each component is unevenly distributed or some of the components are unevenly present, but is preferably in the form of the composition.

The surface treating agent of the embodiment of the invention preferably contains a solvent. The surface treating agent of the embodiment of the invention is more preferably in a form in which the compound (A) is dissolved in a solvent. The form in which the surface treating agent of the embodiment of the invention contains a solvent can be preferably used as a liquid containing the compound (A) to be brought into contact with the surface of the photosensitive layer which is used for forming the above-described protective layer PL.

The preferred form of the solvent that can be contained in the surface treating agent of the embodiment of the invention is the same as the preferred form of the solvent that can be used for the liquid containing the compound (A).

A content of the compound (A) in the surface treating agent of the embodiment of the invention is not particularly limited. In order to make the form in which the surface treating agent of the embodiment of the invention as it is can be applied to the surface of the perovskite-type crystal film, it is preferable that the surface treating agent of the embodiment of the invention be in the form in which the compound (A) is dissolved in a solvent, and that a content of the compound (A) in this surface treating agent is from 0.01 to 100 mM. The content of the compound (A) in the surface treating agent is more preferably from 0.1 to 100 mM, and even more preferably from 1 to 100 mM.

In addition, in a case where the surface treating agent of the embodiment of the invention does not contain a solvent, the surface treating agent can be dissolved or dispersed in a solvent so as to be used in a case of applying the agent to the surface of the perovskite-type crystal film. In addition, in a case where the surface treating agent of the embodiment of the invention is applied to the surface of the perovskite-type crystal film, the surface treating agent in a form of being diluted with a solvent may be used.

A method of applying the surface treating agent of the embodiment of the invention to the perovskite-type crystal film is not particularly limited, and any of a wet-type method or a dry-type method may be adopted. From the viewpoint of manufacture, the wet-type method is preferable, and it is more preferable to adopt an application method. Preferable examples of the application method include known application methods such as spin coating, extrusion die coating, blade coating, bar coating, screen printing, stencil printing, roll coating, curtain coating, spray coating, dip coating, ink jet printing method, and immersion methods. Among these, a spin coating method or a screen printing method is preferable.

Hereinafter, the present invention will be described in more detail based on examples, but the present invention is not limited to these aspects.

### EXAMPLES

The photoelectric conversion element 10A illustrated in Fig. 1 was manufactured in the following procedure. In a case where the film thickness of the photosensitive layer 13 is large, this case corresponds to the photoelectric conversion element 10B illustrated in Fig. 2.

[Manufacturing of photoelectric conversion element (sample No. 101)]

### <Production of conductive support 11>

A fluorine-doped SnO₂ conductive film (transparent electrode 11b, film thickness: 300 nm) was formed on a glass substrate (support 11a, thickness: 2.2 mm) to prepare the conductive support 11.

### <Preparation of solution for blocking layer>

15% by mass isopropanol solution (manufactured by Sigma-Aldrich Co. LLC) of titanium diisopropoxide bis(acetylacetonate) was diluted with 1-butanol, thereby preparing 0.02 M solution for a blocking layer.

### <Formation of blocking layer 14>

The blocking layer 14 (film thickness: 100 nm) formed from titanium oxide was formed on the SnO₂ conductive film of the conductive support 11 by using the prepared 0.02 M solution for the blocking layer at 450°C in accordance with a spray pyrolysis method.

### <Preparation of titanium oxide paste>

Ethyl cellulose, lauric acid, and terpineol were added to an ethanol dispersion liquid of titanium oxide (anatase, average particle size: 20 nm), thereby preparing titanium oxide paste.

### <Formation of porous layer 12>

The prepared titanium oxide paste was applied onto the blocking layer 14 with a screen printing method, and was baked. This titanium oxide paste was applied and baked twice, respectively. In regard to a baking temperature, first baking was performed at 130°C and second baking was performed at 500°C for 1 hour. A baked body of the titanium oxide, which was obtained, was immersed in 40 mM TiCl4 aqueous solution, and was heated at 60°C for 1 hour, and heating was continuously performed at 500°C for 30 minutes, thereby forming the porous layer 12 (film thickness: 250 nm) formed from TiO₂.

### <Formation of photosensitive layer 13A>

A methanol solution (27.86 mL) of 40% by mass of methyl amine, and an aqueous solution (30 mL) of 57% by mass of hydrogen iodide (hydriodic acid) were stirred in a flask at 0°C for 2 hours, and were concentrated, and therefore coarse CH₃NH₃I was obtained. The coarse CH₃NH₃I obtained was dissolved in ethanol and was recrystallized with diethylether. A precipitated crystal was filtered and collected, and was dried under reduced pressure at 60°C for 24 hours, and therefore purified CH₃NH₃I was obtained.

Next, the purified CH₃NH₃I and PbI₂ were stirred and mixed at a molar ratio of 3:1 (CH₃NH₃I:PbI₂) in N,N-dimethylformamide at 60°C for 12 hours, and then the resultant mixture was filtered with a polytetrafluoroethylene (PTFE) syringe filter, thereby preparing a light absorbing agent composition (solution) having a solid content of 40% by mass.

The prepared light absorbing agent composition was applied (application temperature: 60°C) onto the porous layer 12 by a spin coating method (60 seconds at 2000 rpm), and the applied light absorbing agent solution A was dried by using a hot plate at 100°C for 60 minutes, and therefore the photosensitive layer 13A including a perovskite compound of CH₃NH₃PbI₃ was obtained.

In this manner, the first electrode 1A was produced.

### <Preparation of surface treating agent>

The compound 1 was dissolved in chlorobenzene as the compound (A), and the insoluble matter was removed by filtration through a PTFE syringe filter, thereby preparing a surface treating agent (solution) containing the compound 1 at a concentration of 10 mM. This surface treating agent was applied to the surface of the photosensitive layer 13A of the first electrode 1A (25 mm × 25 mm) by a spin coating method (3000 rpm, 30 seconds), and then dried at 100°C for 30 minutes, thereby forming the protective layer PL. The total film thickness of the porous layer 12, photosensitive layer 13, and protective layer PL was 300 nm.

### <Formation of hole transport layer 3>

Next, the hole transporting material solution was applied on the surface of the first electrode 1 on which the protective layer PL is formed by a spin coating method, and the applied hole transporting material solution was dried, and therefore a hole transport layer 3 (having a film thickness of 0.1 µm) was formed.

### <Production of second electrode 2>

Gold (film thickness of 0.1 µm) was vapor-deposited on the hole transport layer 3 by vapor-deposition method, and therefore the second electrode 2 was produced.

In this manner, the photoelectric conversion element 10 of the sample No. 1 01 was manufactured.

Each film thickness was determined by observation with SEM.

### [Manufacturing of photoelectric conversion elements (sample Nos. 102 to 151)]

In the manufacture of the photoelectric conversion element of the sample No. 101, the perovskite compound of the photosensitive layer is as shown in Table 1, or the kind and concentration of the compound (A) used for the surface treating agent, and the solvent are as shown in Table 1. Furthermore, formulation is performed such that a concentration of an organic ammonium salt or CsI in the surface treating agent became 10 mM as shown in Table 1, and in the same manner as the manufacture of the photoelectric conversion element of the sample No. 101, the photoelectric conversion elements of sample Nos. 102 to 151 were obtained. In a case where the perovskite compound formed in the photosensitive layer 13 was NH₂CH=NH₂PbI₃, a drying temperature after application of the surface treating agent was set to 150°C.

The sample No. 150 is an example (example of the related art) in which the protective layer is not provided on the surface of the photosensitive layer 13, and the sample No. 151 is a comparative example in which a step of forming the protective layer was carried out with only chlorobenzene as the surface treating agent.

In Table 1, the number of the compound (A) corresponds to the number of the compound exemplified as above. The term "CB" is chlorobenzene, the term "IPA" is isopropyl alcohol, and the term "Tol" is toluene.

### [Evaluation of moisture resistance]

Seven samples for each of the photoelectric conversion elements of each sample number were manufactured. A cell characteristic test was performed on the seven samples of each of the manufactured photoelectric conversion elements so as to obtain a photoelectric conversion efficiency. Measurement results were taken as an initial photoelectric conversion efficiency.

The cell characteristic test was performed by irradiating each photoelectric conversion element with pseudo-solar light of 1000 W/m² from a xenon lamp through an AM 1.5 filter by using a solar simulator "PEC-L15" (manufactured by Peccell Technologies, Inc.). The photoelectric conversion efficiency was obtained by measuring the current-voltage characteristics of each photoelectric conversion element irradiated with pseudo-solar light using a source meter "Keithley 2401" (manufactured by TEKTRONIX, INC.).

The Initial photoelectric conversion efficiency of each of the photoelectric conversion elements described above an efficiency with which the photoelectric conversion element or the solar cell functions sufficiently.

These samples were stored under conditions of 45°C and a relative humidity of 55% for 24 hours, and then the cell characteristic test was carried out again to obtain the photoelectric conversion efficiency. Measurement results were taken as a photoelectric conversion efficiency after a lapse of time. A reduction rate of the photoelectric conversion efficiency of each sample was calculated by the following formula.

Reduction rate = 1 - photoelectric conversion efficiency after a lapse of time/initial photoelectric conversion efficiency

For each of the photoelectric conversion elements of each sample number, an average of the reduction rates of the seven samples was calculated. The calculated value was taken as the average reduction rate.

Next, a relative reduction rate of each photoelectric conversion element to the sample No. 150 (a value obtained by dividing the average reduction rate of each photoelectric conversion element by the average reduction rate of the sample No. 150) in a case where the average reduction rate of the sample No. 150 is 1, was calculated.

Whether the relative reduction rate was included in any of the following evaluation standards was determined.

The performance of evaluation of "F" or higher is practically required, and the evaluation of "E" or higher is preferable. The lower the relative reduction rate, the better the moisture resistance is.
AA: The relative reduction rate is less than 0.60
A: The relative reduction rate is 0.60 or more and less than 0.65
B: The relative reduction rate is 0.65 or more and less than 0.70
C: The relative reduction rate is 0.70 or more and less than 0.75
D: The relative reduction rate is 0.75 or more and less than 0.80
E: The relative reduction rate is 0.80 or more and less than 0.85
F: The relative reduction rate is 0.85 or more and less than 0.95
G: The relative reduction rate is 0.95 or more

### [Evaluation of stability of film form]

The stability of the film form was evaluated using the first electrode of the photoelectric conversion elements of each sample number (that is, in the manufacture of the photoelectric conversion elements of each sample number, the stability of the film form was evaluated using the sample of the aspect in which the hole transport layer and the second electrode are not formed).

Three samples of each of the first electrodes (25 mm square substrates) of the photoelectric conversion elements of each sample number were prepared and stored for 48 hours under the environment of a temperature of 25°C and a humidity of 50% RH. Thereafter, regarding the film form of the photosensitive layer of the first electrode, the surface shape and tint were respectively observed by Scanning Electron Microscope (SEM) and visually, and the stability of the photosensitive layer was evaluated based on the following evaluation standard. The observation with a scanning electron microscope (SEM) was carried out at three points (n = 3) near the center of each sample at an acceleration voltage of 2 kV after each sample after the humidity test was coated with osmium (Os). The evaluation results of the three samples of the same composition were all the same. In the following evaluation A, the crystal structure of the surface of the photosensitive layer is not decomposed, and as going towards from the evaluation B to evaluation D, the crystal structure of the surface of the photosensitive layer is more decomposed.

### -Evaluation standard for stability of film form-

The brownish-red mirror surface of the photosensitive layer is
A: Almost no change
B: White turbidity occurs and fine unevenness are formed on the film surface
C: Turning into gray, and unevenness is formed on the film surface
D: Turning into gray, and voids are formed in the film surface

**[Table 1]**

| Sample No. | Photosensitive layer | Surface treating agent | | | | | Evaluation result | | Note |
|---|---|---|---|---|---|---|---|---|---|
| | Perovskite compound | Compound (A) | Solvent | Solvent mixing ratio (weight ratio) | Concentration of compound (A) in surface treating agent | Organic ammonium salt | Moisture resistance | Film form | |
| 101 | CH₃NH₃PbI₃ | 59 | CB | - | 10 mM | - | C | B | Present invention |
| 102 | CH₃NH₃PbI₃ | 60 | CB | - | 10 mM | - | D | C | Present invention |
| 103 | CH₃NH₃PbI₃ | 61 | CB | - | 10 mM | - | D | C | Present invention |
| 104 | CH₃NH₃PbI₃ | 62 | CB | - | 10 mM | - | C | B | Present invention |
| 105 | CH₃NH₃PbI₃ | 63 | CB | - | 10 mM | - | C | B | Present invention |
| 106 | CH₃NH₃PbI₃ | 64 | CB | - | 10 mM | - | D | C | Present invention |
| 107 | CH₃NH₃PbI₃ | 65 | CB | - | 10 mM | - | D | C | Present invention |
| 108 | CH₃NH₃PbI₃ | 66 | CB | - | 10 mM | - | D | C | Present invention |
| 109 | CH₃NH₃PbI₃ | 67 | CB | - | 10 mM | - | D | C | Present invention |
| 110 | CH₃NH₃PbI₃ | 68 | CB | - | 10 mM | - | D | C | Present invention |
| 111 | CH₃NH₃PbI₃ | 69 | CB | - | 10 mM | - | D | C | Present invention |
| 112 | CH₃NH₃PbI₃ | 103 | CB | - | 10 mM | - | E | C | Present invention |
| 113 | CH₃NH₃PbI₃ | 104 | CB | - | 10 mM | - | E | C | Present invention |
| 114 | CH₃NH₃PbI₃ | 105 | CB | - | 10 mM | - | A | A | Present invention |
| 115 | CH₃NH₃PbI₃ | 106 | CB | - | 10 mM | - | A | A | Present invention |
| 116 | CH₃NH₃PbI₃ | 107 | CB | - | 10 mM | - | A | A | Present invention |
| 117 | CH₃NH₃PbI₃ | 108 | CB | - | 10 mM | - | A | A | Present invention |
| 118 | CH₃CH₂NH₃PbI₃ | 108 | CB | - | 10 mM | - | A | A | Present invention |
| 119 | NH₂CH=NH₂PbI₃ | 108 | CB | - | 10 mM | - | A | A | Present invention |
| 120 | CH₃NH₃PbBr₃ | 108 | CB | - | 10 mM | - | A | A | Present invention |
| 121 | CH₃NH₃PbI₃ | 108 | CB/IPA | 99/1 | 10 mM | - | A | A | Present invention |
| 122 | CH₃NH₃PbI₃ | 108 | CB/IPA | 80/20 | 10 mM | - | A | A | Present invention |
| 123 | CH₃NH₃PbI₃ | 108 | CB/IPA | 50/50 | 10 mM | - | A | A | Present invention |
| 124 | CH₃NH₃PbI₃ | 108 | CB/IPA | 20/80 | 10 mM | - | B | B | Present invention |
| 125 | CH₃NH₃PbI₃ | 108 | IPA | - | 10 mM | - | C | B | Present invention |
| 126 | CH₃NH₃PbI₃ | 108 | Tol | - | 10 mM | - | A | A | Present invention |
| 127 | CH₃NH₃PbI₃ | 108 | CB | - | 0.005 mM | - | B | B | Present invention |
| 128 | CH₃NH₃PbI₃ | 108 | CB | - | 0.01 mM | - | A | A | Present invention |
| 129 | CH₃NH₃PbI₃ | 108 | CB | - | 50 mM | - | A | A | Present invention |
| 130 | CH₃NH₃PbI₃ | 108 | CB | - | 100 mM | - | A | A | Present invention |
| 131 | CH₃NH₃PbI₃ | 108 | CB | - | 200 mM | - | B | B | Present invention |
| 132 | CH₃NH₃PbI₃ | 108 | CB | - | 10 mM | CH₃NH₃I | A | A | Present invention |
| 133 | CH₃NH₃PbI₃ | 108 | CB | - | 10 mM | CH₃CH₂NH₃I | A | A | Present invention |
| 134 | CH₃NH₃PbI₃ | 108 | CB | - | 10 mM | CH(=NH)NH₃I | A | A | Present invention |
| 135 | CH₃NH₃PbI₃ | 108 | CB | - | 10 mM | CsI | A | A | Present invention |
| 136 | CH₃NH₃PbI₃ | 109 | CB | - | 10 mM | - | A | A | Present invention |
| 137 | CH₃NH₃PbI₃ | 111 | CB | - | 10 mM | - | A | A | Present invention |
| 138 | CH₃NH₃PbI₃ | 112 | CB | - | 10 mM | - | D | C | Present invention |
| 139 | CH₃NH₃PbI₃ | 48 | CB | - | 10 mM | - | D | C | Present invention |
| 140 | CH₃NH₃PbI₃ | 70 | CB | - | 10 mM | - | D | C | Present invention |
| 141 | CH₃NH₃PbI₃ | 1 | CB | - | 10 mM | - | B | B | Present invention |
| 142 | CH₃NH₃PbI₃ | 4 | CB | - | 10 mM | - | B | B | Present invention |
| 143 | CH₃NH₃PbI₃ | 5 | CB | - | 10 mM | - | B | B | Present invention |
| 144 | CH₃NH₃PbI₃ | 12 | CB | - | 10 mM | - | B | B | Present invention |
| 145 | CH₃NH₃PbI₃ | 28 | CB | - | 10 mM | - | B | B | Present invention |
| 146 | CH₃NH₃PbI₃ | 33 | CB | - | 10 mM | - | B | B | Present invention |
| 147 | CH₃NH₃PbI₃ | 86 | CB | - | 10 mM | - | AA | A | Present invention |
| 148 | CH₃NH₃PbI₃ | 86 | CB/IPA | 99/1 | 10 mM | CH(=NH)NH₃I | AA | A | Present invention |
| 149 | CH₃NH₃PbI₃ | 113 | CB | - | 10 mM | - | C | B | Present invention |
| 150 | CH₃NH₃PbI₃ | - | - | - | - | - | G | D | Example of related art |
| 151 | CH₃NH₃PbI₃ | - | CB | - | - | - | G | D | Comparative Example |

As shown in Table 1, the result was that the photoelectric conversion elements of the sample Nos. 150 and 151 having no protective layer on the surface of the second electrode side of the photosensitive layer side were inferior in the moisture resistance. It is conceivable that the photosensitive layers of the sample Nos. 150 and 151 showed that the crystal structure of the photosensitive layer was likely to be damaged under a high-humidity environment, and this damage of the crystal structure deteriorated the moisture resistance of the elements.

On the contrary, it was found that the photoelectric conversion elements of the sample Nos. 101 to 149 which are the photoelectric conversion elements of the embodiment of the invention in which the protective layer defined by the present invention is formed on the surface of the photosensitive layer, had a small reduction range in the photoelectric conversion efficiency even being used under a high-humidity environment, and had remarkably improved moisture resistance. In the photosensitive layers of the photoelectric conversion elements of the sample Nos. 101 to 149, the crystal structures of the photosensitive layers were unlikely to be damaged under a high-humidity environment, and it was also found that the protective layer on the surface of the photosensitive layer effectively suppressed damage of the crystal structure of the photosensitive layer.

While the present invention has been described together with the embodiments thereof, any detail in the descriptions is not intended to limit the invention unless otherwise specified and is perceived to be interpreted widely without infringing the spirit and scope of the invention as set forth in the appended claims.

Priority is claimed on JP2016-168770 filed on August 31, 2016 in Japan, the content of which is incorporated in the present specification by reference as a part.

### EXPLANATION OF REFERENCES

1A to 1F: first electrode
11: conductive support
11a: support
11b: transparent electrode
12: porous layer
13A to 13C: photosensitive layer
14: blocking layer
2: second electrode
3A, 3B, 16: hole transport layer
4, 15: electron transport layer
PL: protective layer
6: external circuit (lead)
10A to 10F: photoelectric conversion element
100A to 100F: system using solar cell
M: electric motor

## Claims

1. A photoelectric conversion element, comprising:
a first electrode that includes a photosensitive layer containing a light absorbing agent on a conductive support; and
a second electrode that is opposite to the first electrode,
wherein the light absorbing agent contains a compound having a perovskite-type crystal structure that has an organic cation, a cation of a metal atom, and an anion,
the photoelectric conversion element further comprising a protective layer that includes a compound having a molecular weight of 5000 or less which is represented by Formula (A), on a surface side of the second electrode of the photosensitive layer:
Formula (A) R^{A}-Z
in Formula (A), R^{A} represents an alkyl group, an alkenyl group, an alkynyl group, a cycloalkyl group, an aryl group, a heteroaryl group, or an aliphatic heterocyclic group, provided that R^{A} does not have a silyl group as a substituent; and Z represents an acidic group or a salt thereof.

2. The photoelectric conversion element according to claim 1,
wherein, in a case where R^{A} is an alkyl group, the alkyl group is in an unsubstituted form or has a halogen atom, a cycloalkyl group, and/or an aryl group as a substituent,
in a case where R^{A} is an alkenyl group or an alkynyl group, the alkenyl group and the alkynyl group are in an unsubstituted form or have a halogen atom, an 1-alkenyl group, an 1-alkynyl group, a cycloalkyl group, and/or an aryl group as a substituent, and
in a case where R^{A} is a cycloalkyl group, an aryl group, a heteroaryl group, or an aliphatic heterocyclic group, the cycloalkyl group, the aryl group, the heteroaryl group, and the aliphatic heterocyclic group are in an unsubstituted form or have a halogen atom, an alkyl group, an alkenyl group, an alkynyl group, a cycloalkyl group, and/or an aryl group as a substituent.

3. The photoelectric conversion element according to claim 1 or 2,
wherein R^{A} is an alkyl group having 7 to 30 carbon atoms, or a cycloalkyl group or an aryl group.

4. The photoelectric conversion element according to claim 3, wherein R^{A} is represented by Formula (r1): 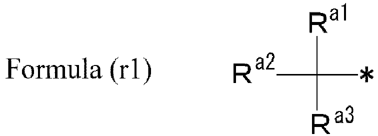 in Formula, R^{a1} and R^{a2} represent a halogen atom, an alkyl group, an alkenyl group, an alkynyl group, a cycloalkyl group, or an aryl group, R^{a3} represents a hydrogen atom, a halogen atom, an alkyl group, an alkenyl group, an alkynyl group, a cycloalkyl group, or an aryl group, and * represents a binding site with Z.

5. The photoelectric conversion element according to claim 4,
wherein the number of carbon atoms of R^{A} is 7 to 30.

6. The photoelectric conversion element according to any one of claims 1 to 5,
wherein the Z is -COOH or a salt thereof, -SO₃H or a salt thereof, -P(=O)(OH)₂ or a salt thereof, or -B(OH)₂ or a salt thereof.

7. The photoelectric conversion element according to claim 6,
wherein the Z is -SO₃H or a salt thereof, or -P(=O)(OH)₂ or a salt thereof.

8. The photoelectric conversion element according to claim 7,
wherein the Z is -P(=O)(OH)₂ or a salt thereof.

9. A solar cell which is formed of the photoelectric conversion element according to any one of claims 1 to 8.

10. A method for manufacturing a photoelectric conversion element which includes a first electrode that includes a photosensitive layer containing a light absorbing agent on a conductive support, and a second electrode that is opposite to the first electrode,
wherein the light absorbing agent contains a compound having a perovskite-type crystal structure that has an organic cation, a cation of a metal atom, and an anion,
the method comprising: after forming the photosensitive layer on the conductive support, bringing the photosensitive layer into contact with a solution containing a compound having a molecular weight of 5000 or less which is represented by Formula (A), to form a protective layer containing the compound on a surface of the photosensitive layer:
Formula (A) R^{A}-Z
in Formula (A), R^{A} represents an alkyl group, an alkenyl group, an alkynyl group, a cycloalkyl group, an aryl group, a heteroaryl group, or an aliphatic heterocyclic group, provided that R^{A} does not have a silyl group as a substituent; and Z represents an acidic group or a salt thereof.

11. A surface treating agent for a perovskite-type crystal film, comprising:
a compound having a molecular weight of 5000 or less which is represented by Formula (A):
Formula (A) R^{A}-Z
in Formula (A), R^{A} represents an alkyl group, an alkenyl group, an alkynyl group, a cycloalkyl group, an aryl group, a heteroaryl group, or an aliphatic heterocyclic group, provided that R^{A} does not have a silyl group as a substituent; and Z represents an acidic group or a salt thereof.

12. The surface treating agent for a perovskite-type crystal film according to claim 11,
wherein, in a case where R^{A} is an alkyl group, the alkyl group is in an unsubstituted form or has a halogen atom, a cycloalkyl group, and/or an aryl group as a substituent,
in a case where R^{A} is an alkenyl group or an alkynyl group, the alkenyl group and the alkynyl group are in an unsubstituted form or have a halogen atom, an 1-alkenyl group, an 1-alkynyl group, a cycloalkyl group, and/or an aryl group as a substituent, and
in a case where R^{A} is a cycloalkyl group, an aryl group, a heteroaryl group, or an aliphatic heterocyclic group, the cycloalkyl group, the aryl group, the heteroaryl group, and the aliphatic heterocyclic group are in an unsubstituted form or have a halogen atom, an alkyl group, an alkenyl group, an alkynyl group, a cycloalkyl group, and/or an aryl group as a substituent.

13. The surface treating agent for a perovskite-type crystal film according to claim 11 or 12, further comprising:
a solvent.

14. The surface treating agent for a perovskite-type crystal film according to claim 13,
wherein the solvent includes an aprotic solvent.

15. The surface treating agent for a perovskite-type crystal film according to claim 13,
wherein the solvent includes an aprotic solvent and an alcohol, and
a content of the alcohol in the solvent is from 1% to 50% by mass.

16. The surface treating agent for a perovskite-type crystal film according to any one of claims 13 to 15,
wherein a content of a compound having a molecular weight of 5000 or less which is represented by Formula (A) is 0.01 to 100 mM in the surface treating agent for a perovskite-type crystal film.
